# EUROPEAN PATENT SPECIFICATION

(11) **EP 4 687 299 B1**
(45) Date of publication and mention of the grant of the patent: **02.09.2026**
(21) Application number: 25157882.9
(22) Date of filing: 14.02.2025
(51) Int. Cl.: H03M 13/11, H03M 13/37, G06F 11/10

(54) **DECODERS, DECODING METHODS, MEMORY SYSTEMS, AND OPERATING METHODS AND CONTROLLERS THEREOF**
DECODIERER, DECODIERUNGSVERFAHREN, SPEICHERSYSTEME UND BETRIEBSVERFAHREN UND STEUERGERÄTE DAFÜR
DÉCODEURS, PROCÉDÉS DE DÉCODAGE, SYSTÈMES DE MÉMOIRE ET PROCÉDÉS DE FONCTIONNEMENT ET CONTRÔLEURS ASSOCIÉS

(30) Priority: 29.07.2024 CN 202411027509
(43) Date of publication of application: 04.02.2026
(73) Proprietor: Yangtze Memory Technologies Co., Ltd., Wuhan, Hubei 430000 (CN)
(72) Inventor: Zhuang, Zhiwei, Wuhan, Hubei, 430000 (CN)
(74) Representative: Gramm, Lins & Partner Patent- und Rechtsanwälte PartGmbB

(56) References cited:
- US-A1- 2023 308 114
- HUANG YUANG ET AL: "Syndrome-Aided Gradient Descent Bit Flipping Algorithm for LDPC Decoding", 2020 IEEE 6TH INTERNATIONAL CONFERENCE ON COMPUTER AND COMMUNICATIONS (ICCC), 14 December 2020 (2020-12-14), pages 659 - 663, XP093296440, ISBN: 978-1-7281-8635-1, Retrieved from the Internet <URL:https://ieeexplore.ieee.org/abstract/document/9345227> [retrieved on 20250717], DOI: 10.1109/ICCC51575.2020.9345227
- JIANG MING ET AL: "A Low-Latency BF Decoding of LDPC Codes With Dynamic Thresholds", IEEE COMMUNICATIONS LETTERS, IEEE SERVICE CENTER, PISCATAWAY, NJ, US, vol. 25, no. 9, 11 June 2021 (2021-06-11), pages 2781 - 2785, XP011877153, ISSN: 1089-7798, [retrieved on 20210908], DOI: 10.1109/LCOMM.2021.3088579
- JUNHO CHO ET AL: "Adaptive Threshold Technique for Bit-Flipping Decoding of Low-Density Parity-Check Codes", IEEE COMMUNICATIONS LETTERS, IEEE SERVICE CENTER, PISCATAWAY, NJ, US, vol. 14, no. 9, 1 September 2010 (2010-09-01), pages 857 - 859, XP011316011, ISSN: 1089-7798

## Description

### TECHNICAL FIELD

The present disclosure relates to the field of semiconductor technologies, and in particular, to decoders, decoding methods, memory systems, and operating methods and controllers thereof.

### BACKGROUND

Memory devices are storage devices in modern information technology for storing information. As a typical non-volatile semiconductor memory, NAND (Not-And) type memories gradually become mainstream products in the storage market due to high storage density, controllable production cost, and suitable erase speed. However, as people's requirements on storage devices continue to increase, memory devices and systems thereof still have significant room for improvement.

US 2023/0308114 A1 discloses a dynamic bit-flipping decoder that selects least-reliable bits via an energy function, maps syndrome weight to a flipping criterion using a lookup table, and stops on a null syndrome.

Huang and Liu, "Syndrome-Aided Gradient Descent Bit-Flipping Algorithm for LDPC Decoding," Proc. 2020 IEEE 6th Int'l Conf. on Computer and Communications (ICCC), Chengdu, China, 11-14 Dec. 2020, doi:10.1109/ICCC51575.2020.9345227, discloses a syndrome-aided GDBF that adjusts multi-bit flipping thresholds from syndrome values during iterations.

Jiang and Fan, "A Low-Latency BF Decoding of LDPC Codes With Dynamic Thresholds," IEEE Communications Letters, vol. 25, no. 9, pp. 2781-2785, Sept. 2021, discloses a BF decoder that updates a dynamic flipping threshold using prior-iteration flipping results to cut latency.

Cho and Sung, "Adaptive Threshold Technique for Bit-Flipping Decoding of Low-Density Parity-Check Codes," IEEE Communications Letters, vol. 14, no. 9, pp. 857-859, Sept. 2010, discloses an adaptive-threshold BF scheme that computes bit energies by counting unsatisfied parity checks per bit.

### SUMMARY

The implementations of the present disclosure provides decoders, memory systems, and operating methods thereof.

A first aspect relates to a decoder according to claim 1.

In some implementations, the processor is configured to: determine that the flipping threshold in the current iteration is less than the flipping threshold in a previous iteration, based on the check expression weight decreasing sequentially in the current iteration and at least two previous iterations; or determine that the flipping threshold in the current iteration is greater than the flipping threshold in the previous iteration, based on the check expression weight increasing sequentially in the current iteration and the at least two previous iterations; or determine that the flipping threshold in the current iteration is equal to the flipping threshold in the previous iteration based on the check expression weight remaining unchanged or alternating between decreasing and increasing in the current iteration and the at least two previous iterations.

In some implementations, the processor is configured to: determine the flipping threshold in the current iteration, based on the changing state of the check expression weight and the maximum energy of a codeword to be decoded in the previous iteration.

In some implementations, the processor is configured to: determine that the flipping threshold in the current iteration is less than the flipping threshold in the previous iteration, based on the check expression weight decreasing sequentially in the current iteration and at least two previous iterations and the maximum energy of the codeword to be decoded in the previous iteration being less than a sum of the flipping threshold of the previous iteration and a step size; or determine that the flipping threshold in the current iteration is greater than the flipping threshold in the previous iteration, based on the check expression weight increasing sequentially in the current iteration and the at least two previous iterations or the maximum energy of the codeword to be decoded in the previous iteration being greater than or equal to the sum of the flipping threshold of the previous iteration and the step size; or determine that the flipping threshold in the current iteration is equal to the flipping threshold in the previous iteration, based on the check expression weight remaining unchanged or alternating between decreasing and increasing in the current iteration and the at least two previous iterations.

In some implementations, the processor is further configured to: determine the flipping threshold in the current iteration, based on the changing state of the check expression weight, the maximum energy of the codeword to be decoded in the previous iteration, and the relationship between a flipping threshold in the previous iteration and the lower limit of the flipping threshold.

In some implementations, the processor is further configured to: determine that the flipping threshold in the current iteration is less than the flipping threshold in the previous iteration, based on the check expression weight decreasing sequentially in the current iteration and at least two previous iterations, and at least one of the following two conditions being satisfied: the maximum energy of the codeword to be decoded in the previous iteration is less than the sum of the flipping threshold of the previous iteration and the step size, and a difference between the flipping threshold in the previous iteration and the step size is greater than the lower limit of the flipping threshold; or determine that the flipping threshold in the current iteration is greater than the flipping threshold in the previous iteration, based on the check expression weight increasing sequentially in the current iteration and the at least two previous iterations, or based on the maximum energy of the codeword to be decoded in the previous iteration being greater than or equal to the sum of the flipping threshold of the previous iteration and the step size and the flipping threshold in the previous iteration being the lower limit of the flipping threshold; or determine that the flipping threshold in the current iteration is equal to the flipping threshold in the previous iteration, based on the check expression weight remaining unchanged or alternating between decreasing and increasing in the current iteration and the at least two previous iterations.

In some implementations, the processor is further configured to: determine that the flipping threshold in the current iteration is equal to the lower limit of the flipping threshold based on the check expression weight decreasing sequentially in the current iteration and the at least two previous iterations, and the maximum energy of the codeword to be decoded in the previous iteration being less than the sum of the flipping threshold of the previous iteration and the step size, and the difference between the flipping threshold in the previous iteration and the step size being less than the lower limit of the flipping threshold; or determine that the flipping threshold in the current iteration is equal to the upper limit of the flipping threshold, based on the check expression weight increasing sequentially in the current iteration and the at least two previous iterations, and the sum of the flipping threshold of the previous iteration and the step size being greater than the upper limit of the flipping threshold.

In some implementations, the processor is further configured to: determine the flipping threshold in the current iteration, based on the number of flipped bits in the previous iteration.

In some implementations, the processor is configured to: determine that the flipping threshold in the current iteration is less than the flipping threshold in the previous iteration, based on the number of flipped bits in the previous iteration being 0.

In some implementations, the processor is configured to: determine a flipping threshold in the first iteration, based on a comparison result of the check expression weight of a codeword to be decoded in the first iteration and an initial check expression weight threshold.

In some implementations, the processor is configured to: determine that the flipping threshold in the first iteration is a first flipping threshold, based on the check expression weight of the codeword to be decoded in the first iteration being greater than or equal to the initial check expression weight threshold; or determine that the flipping threshold in the first iteration is a second flipping threshold based on the check expression weight of the codeword to be decoded in the first iteration being less than the initial check expression weight threshold; the first flipping threshold being greater than the second flipping threshold.

In some implementations, the processor is configured to: determine that the first flipping threshold is the upper limit of the flipping threshold based on the check expression weight of the codeword to be decoded in the first iteration being greater than or equal to the initial check expression weight threshold; or determine that the second flipping threshold is a difference between the upper limit of the flipping threshold and the step size based on the check expression weight of the codeword to be decoded in the first iteration being less than the initial check expression weight threshold, and update the upper limit of the flipping threshold to be the second flipping threshold.

In some implementations, the second processing circuit is configured to: perform a first calculation on the check expression and the check matrix, to obtain the number of errors corresponding to each bit in the codeword to be decoded in the current iteration; obtain a mark value corresponding to each bit in the codeword to be decoded in the current iteration, according to a flipping state of each bit; and perform a second calculation on the number of errors corresponding to each bit in the codeword to be decoded in the current iteration and the mark value, to obtain the energy of the codeword to be decoded in the current iteration.

In some implementations, the bit flipping circuit is configured to: compare energy of each bit in the codeword to be decoded in the current iteration to the flipping threshold in the current iteration; and flip the bit according to the energy of the bit being greater than the flipping threshold in the current iteration, or keep the bit unchanged according to the energy of the bit being less than or equal to the flipping threshold in the current iteration, to obtain a decoded codeword in the current iteration; and output the decoded codeword in the current iteration as a codeword to be decoded in the next iteration.

In some implementations, the first processing circuit is configured to: perform a third calculation on the codeword to be decoded in the current iteration and the check matrix, to obtain the check expression; and calculate the number of bits of 1 in the check expression, to obtain the check expression weight.

In some implementations, the decoder further includes: an output circuit, configured to output the codeword to be decoded in the current iteration as a final decoded codeword, according to each bit of the check expression in the current iteration being 0.

A second aspect relates to a memory system according to claim 10.

In some implementations, the memory system further includes an encoder configured to receive write data and encode the write data; and the memory is further configured to receive the encoded write data.

In some implementations, the memory system includes a controller coupled with the memory, the controller including the decoder and the encoder.

A further implementation of the present disclosure may provide a controller, including: an interface configured to receive read data; and the decoder according to any one of the above implementations, configured to decode a codeword to be decoded in the read data.

A further aspect relates to a decoding method according to claim 13.

In some implementations, the determining the flipping threshold in the current iteration, based on the changing state of the check expression weight, includes: determining that the flipping threshold in the current iteration is less than the flipping threshold in a previous iteration, based on the check expression weight decreasing sequentially in the current iteration and the at least two previous iterations; or determining that the flipping threshold in the current iteration is greater than the flipping threshold in the previous iteration, based on the check expression weight increasing sequentially in the current iteration and the at least two previous iterations; or determining that the flipping threshold in the current iteration is equal to the flipping threshold in the previous iteration, based on the check expression weight remaining unchanged or alternating between decreasing and increasing in the current iteration and the at least two previous iterations.

In some implementations, the decoding method further includes: determining the flipping threshold in the current iteration, based on the changing state of the check expression weight and the maximum energy of a codeword to be decoded in the previous iteration.

In some implementations, the determining the flipping threshold in the current iteration, based on the changing state of the check expression weight and the maximum energy of the codeword to be decoded in the previous iteration, includes: determining that the flipping threshold in the current iteration is less than the flipping threshold in the previous iteration based on the check expression weight decreasing sequentially in the current iteration and at least two previous iterations and the maximum energy of the codeword to be decoded in the previous iteration being less than a sum of the flipping threshold of the previous iteration and a step size; or determining that the flipping threshold in the current iteration is greater than the flipping threshold in the previous iteration, based on the check expression weight increasing sequentially in the current iteration and the at least two previous iterations or the maximum energy of the codeword to be decoded in the previous iteration being greater than or equal to the sum of the flipping threshold of the previous iteration and the step size; or determining that the flipping threshold in the current iteration is equal to the flipping threshold in the previous iteration, based on the check expression weight remaining unchanged or alternating between decreasing and increasing in the current iteration and the at least two previous iterations.

In some implementations, the decoding method further includes: determining the flipping threshold in the current iteration based on the changing state of the check expression weight, the maximum energy of the codeword to be decoded in the previous iteration, and the relationship between a flipping threshold in the previous iteration and the lower limit of the flipping threshold.

In some implementations, the determining the flipping threshold in the current iteration, based on the changing state of the check expression weight, the maximum energy of the codeword to be decoded in the previous iteration, and the relationship between the flipping threshold in the previous iteration and the lower limit of the flipping threshold includes: determining that the flipping threshold in the current iteration is less than the flipping threshold in the previous iteration based on the check expression weight decreasing sequentially in the current iteration and at least two previous iterations, and at least one of the following two conditions being satisfied: the maximum energy of the codeword to be decoded in the previous iteration is less than the sum of the flipping threshold of the previous iteration and the step size, and a difference between the flipping threshold in the previous iteration and the step size is greater than the lower limit of the flipping threshold; or determining that the flipping threshold in the current iteration is greater than the flipping threshold in the previous iteration, based on the check expression weight increasing sequentially in the current iteration and the at least two previous iterations, or based on the maximum energy of the codeword to be decoded in the previous iteration being greater than or equal to the sum of the flipping threshold of the previous iteration and the step size and the flipping threshold in the previous iteration being the lower limit of the flipping threshold; or determining that the flipping threshold in the current iteration is equal to the flipping threshold in the previous iteration based on the check expression weight remaining unchanged or alternating between decreasing and increasing in the current iteration and the at least two previous iterations.

In some implementations, the determining the flipping threshold in the current iteration, based on the changing state of the check expression weight, the maximum energy of the codeword to be decoded in the previous iteration, and the relationship between the flipping threshold in the previous iteration and the lower limit of the flipping threshold includes: determining that the flipping threshold in the current iteration is equal to the lower limit of the flipping threshold, based on the check expression weight decreasing sequentially in the current iteration and the at least two previous iterations, and the maximum energy of the codeword to be decoded in the previous iteration being less than the sum of the flipping threshold of the previous iteration and the step size, and the difference between the flipping threshold in the previous iteration and the step size being less than the lower limit of the flipping threshold; or determining that the flipping threshold in the current iteration is equal to an upper limit of the flipping threshold based on the check expression weight increasing sequentially in the current iteration and the at least two previous iterations, and the sum of the flipping threshold of the previous iteration and the step size being greater than the upper limit of the flipping threshold.

In some implementations, the decoding method further includes: determining the flipping threshold in the current iteration based on the number of flipped bits in the previous iteration.

In some implementations, the determining the flipping threshold in the current iteration, based on the number of flipped bits in the previous iteration, includes: determining that the flipping threshold in the current iteration is less than the flipping threshold in the previous iteration, based on the number of flipped bits in the previous iteration being 0.

In some implementations, the decoding method further includes: determining a flipping threshold in the first iteration, based on a comparison result of the check expression weight of a codeword to be decoded in the first iteration and an initial check expression weight threshold.

In some implementations, the determining the flipping threshold in the first iteration based on the comparison result of the check expression weight of the codeword to be decoded in the first iteration and the initial check expression weight threshold, includes: determining that the flipping threshold in the first iteration is a first flipping threshold, based on the check expression weight of the codeword to be decoded in the first iteration being greater than or equal to the initial check expression weight threshold; or determining that the flipping threshold in the first iteration is a second flipping threshold, based on the check expression weight of the codeword to be decoded in the first iteration being less than the initial check expression weight threshold; the first flipping threshold being greater than the second flipping threshold.

In some implementations, the determining the flipping threshold in the first iteration, based on the comparison result of the check expression weight of the codeword to be decoded in the first iteration and the initial check expression weight threshold, includes: determining that the first flipping threshold is the upper limit of the flipping threshold, based on the check expression weight of the codeword to be decoded in the first iteration being greater than or equal to the initial check expression weight threshold; or determining that the second flipping threshold is a difference between the upper limit of the flipping threshold and the step size, based on the check expression weight of the codeword to be decoded in the first iteration being less than the initial check expression weight threshold, and updating the upper limit of the flipping threshold to be the second flipping threshold.

In some implementations, the obtaining the energy of the codeword to be decoded in the current iteration based on the check matrix, the check expression, and the flipping state of the codeword to be decoded in the current iteration includes: performing a first calculation on the check expression and the check matrix to obtain the number of errors corresponding to each bit in the codeword to be decoded in the current iteration; obtaining a mark value corresponding to each bit in the codeword to be decoded in the current iteration, according to the flipping state of each bit; and performing a second calculation on the number of errors corresponding to each bit in the codeword to be decoded in the current iteration and the mark value, to obtain the energy of the codeword to be decoded in the current iteration.

In some implementations, the outputting the codeword to be decoded in the next iteration based on the comparison result of the energy of the codeword to be decoded in the current iteration and the flipping threshold in the current iteration includes: comparing energy of each bit in the codeword to be decoded in the current iteration to the flipping threshold in the current iteration; and flipping the bit according to the energy of the bit being greater than the flipping threshold in the current iteration, or keeping the bit unchanged according to the energy of the bit being less than or equal to the flipping threshold in the current iteration, to obtain a decoded codeword in the current iteration; and outputting the decoded codeword in the current iteration as a codeword to be decoded in the next iteration.

In some implementations, the obtaining the check expression and the check expression weight based on the codeword to be decoded in the current iteration and the check matrix includes: performing a third calculation on the codeword to be decoded in the current iteration and the check matrix, to obtain the check expression; and calculating a number of bits of 1 in the check expression, to obtain the check expression weight.

In some implementations, the decoding method further includes: outputting the codeword to be decoded in the current iteration as a final decoded codeword, according to each bit of the check expression in the current iteration being 0.

According to a fifth aspect, an implementation of the present disclosure provides an operating method for a memory system, wherein the operating method includes: reading data using a memory; and decoding a codeword to be decoded in the read data using the decoding method according to any one of the foregoing implementations.

In the technical scheme provided by the present disclosure, the flipping threshold is updated in each iteration, the flipping threshold in the current iteration can be determined based on the changing state of the check expression weight, and the codeword to be decoded in the next iteration is output based on the determined flipping threshold in the current iteration and the energy of the codeword to be decoded in the current iteration, so that setting of the flipping threshold in the current iteration is more reasonable, thus the decoding performance can be improved, and the decoding time is reduced.

### BRIEF DESCRIPTION OF DRAWINGS

FIG. 1 is a first schematic diagram of an exemplary system with a memory system according to an implementation of the present disclosure.
FIG. 2 is a schematic diagram of an exemplary memory card with a memory system according to an implementation of the present disclosure.
FIG. 3 is a schematic diagram of an exemplary solid-state drive with a memory system according to an implementation of the present disclosure.
FIG. 4 is a schematic diagram of an exemplary memory device including a peripheral circuit according to an implementation of the present disclosure.
FIG. 5 is a schematic diagram of an exemplary memory including a memory array and a peripheral circuit according to an implementation of the present disclosure.
FIG. 6 is a second schematic diagram of an exemplary system with a memory system according to an implementation of the present disclosure.
FIG. 7 is a first schematic structural diagram of a decoder according to an implementation of the present disclosure.
FIG. 8 is a flowchart of a decoding process according to an implementation of the present disclosure.
FIG. 9 is a second schematic structural diagram of a decoder according to an implementation of the present disclosure.
FIG. 10 is a schematic structural diagram of a first processing circuit according to an implementation of the present disclosure.
FIG. 11 is a schematic structural diagram of a second processing circuit according to an implementation of the present disclosure.
FIG. 12 is a schematic structural diagram of a bit flipping circuit according to an implementation of the present disclosure.
FIG. 13 is a schematic flowchart of an implementation of a decoding method according to an implementation of the present disclosure.
FIG. 14 is a first schematic flowchart of determining a flipping threshold according to an implementation of the present disclosure.
FIG. 15 is a second schematic flowchart of determining a flipping threshold according to an implementation of the present disclosure.
FIG. 16 is a third schematic flowchart of determining a flipping threshold according to an implementation of the present disclosure.
FIG. 17 is a fourth schematic flowchart of determining a flipping threshold according to an implementation of the present disclosure.

### DETAILED DESCRIPTION

Exemplary implementations disclosed in the present disclosure will be described in more detail below with reference to the accompanying drawings. Although exemplary implementations of the present disclosure are shown in the accompanying drawings, it should be understood that the present disclosure may be implemented in various forms and should not be limited to the implementations set forth herein. Rather, these implementations are provided so that the present disclosure can be more thoroughly understood and the scope disclosed in the present disclosure can be fully conveyed to those skilled in the art.

In the following description, numerous details are given in order to provide a more thorough understanding of the present disclosure. However, it will be apparent to one skilled in the art that, the present disclosure may be practiced without one or more of these details. In other examples, in order to avoid confusion with the present disclosure, some technical features known in the art are not described; that is, not all features of the actual implementations are described here, and well-known functions and structures are not described in detail.

In the drawings, like reference numerals refer to like elements throughout.

It should be understood that spatial relation terms such as "beneath," "below," "lower," "under", "above," "upper," etc., may be used herein for ease of description to describe the relationship between one element or feature and other elements or features shown in the figures. It should be appreciated that, in addition to the orientations shown in the figures, the spatial-relation terms intent to also include different orientations of the devices in use and operation. For example, if the devices in the figures are flipped, then described as "below" or "under" or "beneath" other elements or features will be oriented "on" other elements or features. Thus, the exemplary terms "below" and "under" may include both upper and lower orientations. The devices may be additionally oriented (rotated 90 degrees or other orientations) and the spatial description terminology used herein is interpreted accordingly.

A term used herein is for the purpose of describing a particular implementation only and is not to be considered as limitation of the present disclosure. As used herein, the singular forms "a", "an" and "said/the" are intended to include the plural forms as well, unless the context clearly dictates otherwise. It should also be understood that the terms "consists of" and/or "comprising", when used in this description, identify the presence of stated features, integers, steps, operations, elements and/or parts, but do not exclude the presence and addition of one or more other features, integers, steps, operations, elements, parts and/or groups. As used herein, the term "and/or" includes any and all combinations of associated listed items.

To improve reliability of data transfer and data storage, error-correcting code (ECC) technology has been widely used in the field of digital communications, for example, wireless communication and optical fiber communication, and data storage, for example, a memory system. In various error correcting codes, a LDPC (Low Density Parity-Check) code is a sparse matrix-based parallel iterative decoding algorithm, which has the performance of approximating Shannon limit, is simple to decode and can perform parallel operations, and has become one of the most widely used error correcting codes.

As a typical non-volatile semiconductor memory, NAND (Not-And) type memories gradually become mainstream products in the storage market due to high storage density, controllable production cost, and suitable erase speed. In a process of transferring and storing data in a NAND type memory, errors of data may be caused due to hardware faults, software faults, hard disk errors, and the like of the memory. To ensure the integrity of user data, it has been proposed to use LDPC codes to perform error detection and correction on data stored in a memory system including NAND type memory. Hereinafter, the memory system provided by the present disclosure will be described by taking a memory system including a three-dimensional NAND type memory as an example.

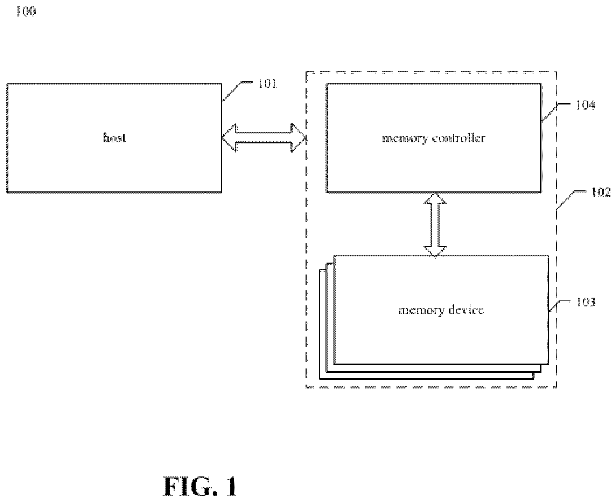

FIG. 1 is a schematic diagram of an exemplary system 100 with a memory system according to an implementation of the present disclosure. In an implementation of the present disclosure, the system 100 may be a mobile phone, a desktop computer, a laptop computer, a tablet computer, a vehicle computer, a game console, a printer, a positioning device, a wearable electronic device, a smart sensor, a virtual reality (VR) device, an augmented reality (AR) device, or any other suitable electronic device having a memory therein. As shown in FIG. 1, the system 100 may include a host 101 and a memory system 102, which may include one or more memory devices 103 and a memory controller 104. The host 101 may include a processor of an electronic device, for example, a central processing unit (CPU), or a system on a chip (SoC), for example, an application processor (AP). The host 101 may be configured to send or receive data to or from the memory system 102.

In some implementations, the memory controller 104 is coupled to the memory device 103 and the host 101 and is configured to control the memory device 103. The memory controller 104 may manage data stored in the memory device 103 and communicate with the host 101. In some implementations, the memory controller 104 is designed to operate in a low duty cycle environment, such as in a secure digital card, compact flash card (CFC), universal serial bus (USB) flash drive, or to operate in other medium for use in electronic devices such as personal computers, digital cameras, mobile phones, and the like. In other implementations, the memory controller 104 is designed to operate in a high duty cycle environment, such as in a solid-state disk or embedded Multi-Media Card (eMMC).

In some implementations, the memory controller 104 and the one or more memory devices 103 may be integrated into various types of storage devices, that is, the memory system 102 may be implemented and packaged into different types of terminal electronics.

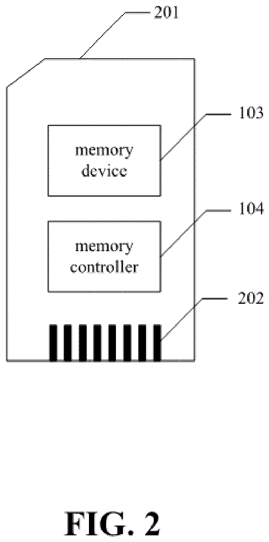

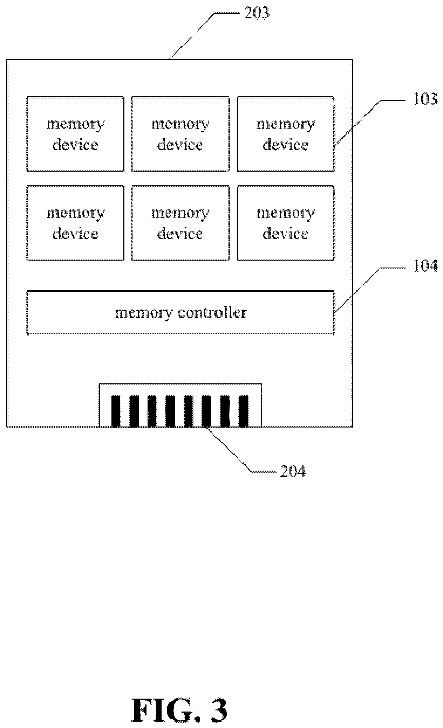

In an example as shown in FIG. 2, the memory controller 104 and the single memory device 103 may be integrated into the memory card 201. The memory card 201 may be one of a compact flash memory card, a smart media card (SMC), a memory stick (MS), a multimedia card (MMC), for example, an RS-MMC, an MMCmicro, an eMMC, or the like, a secure digital card, for example, a Mini SD card, a Micro SD card, an SDHC card, or the like, and a universal flash memory card. The memory card 201 may also include a memory card connector 202 that couples the memory card 201 with a host-side device (e.g., host 101 in FIG. 1). In another example as shown in FIG. 3, the memory controller 104 and a plurality of memory devices 103 may be integrated into an SSD 203. SSD 203 may also include an SSD connector 204 that couples SSD 203 with a host-side device (e.g., host 101 in FIG. 1). In some implementations, the storage capacity and / or operating speed of SSD 203 is greater than the storage capacity and / or operating speed of memory card 201.

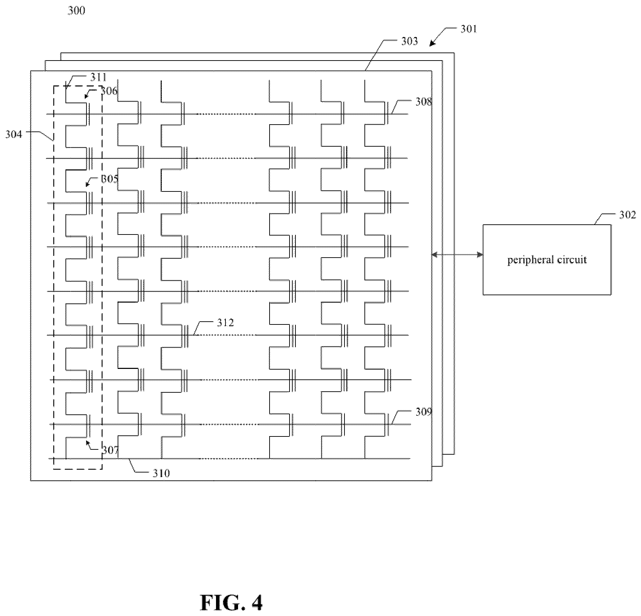

FIG. 4 is a schematic circuit diagram of an exemplary memory device 300 including a peripheral circuit according to an implementation of the present disclosure. The memory device 300 may be an example of the memory device 103 in FIG. 1. The memory device 300 may include a memory array 301 and a peripheral circuit 302 coupled to the memory array 301. Taking the memory array 301 as a 3D NAND type memory array as an example for description, the memory cell 305 is a NAND memory cell, the memory cell 305 is provided in the form of an array of memory cell strings 304, and each memory cell string 304 extends vertically above a substrate (not shown). In some implementations, each memory cell string 304 includes a plurality of memory cells 305 coupled in series and stacked vertically. Each memory cell 305 may maintain a continuous analog value, e.g., voltage or charge, which depends on the number of electrons trapped within a region of memory cell 305. Each memory cell 305 can be either a floating gate type of memory cell including a floating-gate transistor or a charge trap type of memory cell including a charge-trap transistor.

In some implementations, each memory cell 305 is a single level cell (SLC) having two possible memory states and thus may store one bit of data. For example, the first memory state "0" may correspond to a first voltage range and the second memory state "1" may correspond to a second voltage range. In some implementations, each memory cell 305 is a multi-level cell capable of storing more than a single bit of data in four or more memory states, e.g., a multi-level cell (MLC) storing two bits per cell, a triple level cell (TLC) storing three bits per cell, or a quad-level cell (QLC) storing four bits per cell.

As shown in FIG. 4, each memory cell string 304 may include a bottom select transistor (BST) 307 at its source terminal and a top select transistor (TST) 306 at its drain terminal. The bottom select transistor 307 and the top select transistor 306 may be configured to activate the selected memory cell string 304 during read and program operations. In some implementations, the sources of the memory cell strings 304 in the same memory block 303 may be coupled through a common source line (CSL) 310. For example, all the memory cell strings 304 in the same memory block 303 have a common source (ACS). According to some implementations, the top select transistor 306 of each memory cell string 304 is coupled to a respective bit line (BL) 311 from which data can be read or written via an output bus (not shown). In some implementations, each memory cell string 304 is configured to be selected or deselected by applying a select voltage (e.g., a voltage higher than a threshold voltage of the top select transistor 306) or a deselect voltage (e.g., 0V) to a top select gate (TSG) of the respective top select transistor 306 through one or more top select lines (TSL) 308 and/or by applying a select voltage (e.g., a voltage higher than a threshold voltage of the bottom select transistor 307) or a deselect voltage (e.g., 0V) to a bottom select gate (BSG) of the respective bottom select transistor 307 through one or more bottom select lines (BSL) 309.

As shown in FIG. 4, the memory cell string 304 may be organized into a plurality of memory blocks 303, each of which may have a common source line 310. In some implementations, each memory block 303 is a basic data unit for an erase operation, e.g., all memory cells 305 on the same memory block 303 are erased simultaneously. To erase the memory cells 305 in the selected memory block, a common source line 310 coupled to the selected memory block and an unselected memory block in the same side as the selected memory block may be biased with an erase voltage. It should be understood that, in some examples, erase operations may be performed at a half-memory block level, at a quarter-memory block level, or at a level with any suitable number of memory blocks or any suitable fraction of a memory block. Memory cells 305 of adjacent memory cell strings 304 may be coupled by word lines 312 that select which rows of memory cells 305 are affected by read or program operations.

In some implementations, the peripheral circuit 302 may include any suitable analog, digital, and mixed-signal circuit to enable operation of the memory array 301 by applying voltage signals and/or current signals to and sensing voltage signals and/or current signals from each of target memory cells 305 through the bit lines 311, the word lines 312, the common source lines 310, the bottom select lines 309, and the top select lines 308. The peripheral circuit 302 may include various types of peripheral circuits formed using metal-oxide-semiconductor technology.

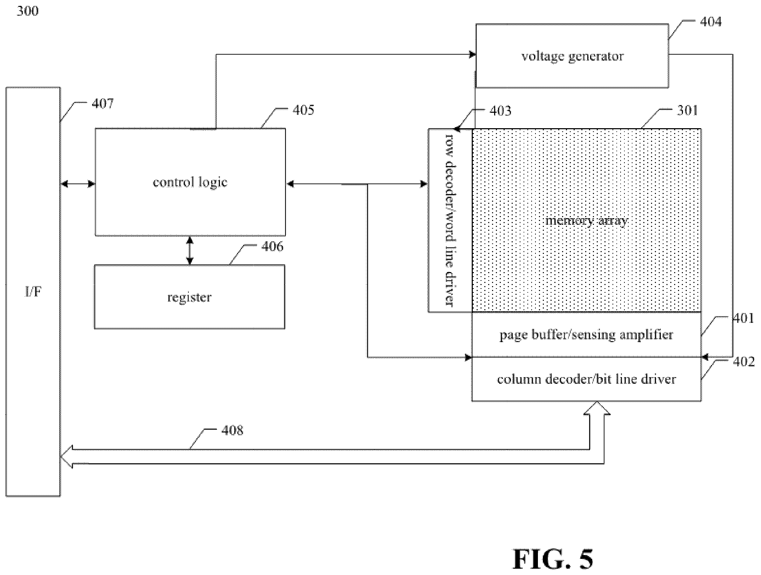

FIG. 5 shows some exemplary peripheral circuits 302 including a page buffer / sensing amplifier 401, a column decoder / bit line driver 402, a row decoder / word line driver 403, a voltage generator 404, control logic 405, a register bank 406, a flash memory interface 407, and a data bus 408. It should be understood that, in some examples, additional peripheral circuits not shown in FIG. 5 may also be included.

The page buffer / sensing amplifier 401 may be configured to read data from and program (write) data to the memory array 301 according to control signals from the control logic 405. In an example, the page buffer / sensing amplifier 401 may store a page of programming data (written data) to be programmed to the memory array 301. In another example, the page buffer / sensing amplifier 401 may perform a programming verification operation to ensure that data has been properly programmed into memory cells coupled to the selected word line. In yet another example, the page buffer / sensing amplifier 401 may also sense a low power signal from the bit line representing a data bit stored in the memory cell, and amplify a small voltage swing to an identifiable logic level in a read operation. The column decoder / bit line driver 402 may be configured to be controlled by the control logic 405 and select one or more memory cell strings by applying a bit line voltage generated from the voltage generator 404.

The row decoder / word line driver 403 may be configured to be controlled by the control logic 405 and select / deselect a memory block of the memory array 301 and select / deselect a word line of the memory block. The row decoder / word line driver 403 may also be configured to drive a word line using the word line voltage generated from the voltage generator 404. In some implementations, the row decoder / word line driver 403 may also select / deselect and drive the bottom select line and the top select line. As described in detail below, the row decoder / word line driver 403 is configured to perform a programming operation on memory cells coupled to the selected word line (s). The voltage generator 404 may be configured to be controlled by the control logic 405 and generate word line voltages (e.g., reading voltages, programming voltages, passing voltages, local voltages, verifying voltages, etc.), bit line voltages, and source line voltages to be supplied to the memory array 301.

The control logic 405 may be coupled to each peripheral circuit described above and configured to control operation of each peripheral circuit. Register bank 406 may be coupled to control logic 405 and include status registers, command registers, and address registers for storing status information, command operation codes (OP codes), and command addresses for controlling operation of each peripheral circuit. The flash memory interface 407 may be coupled to the control logic 405 and act as a control buffer to buffer control commands received from a host-side device (not shown) and relay them to the control logic 405 and buffer status information received from the control logic 405 and relay it to a memory controller. The flash memory interface 407 may also be coupled to the column decoder / bit line driver 402 via the data bus 408, and act as a data I/O interface and a data buffer to buffer and relay data to or from the memory array 301.

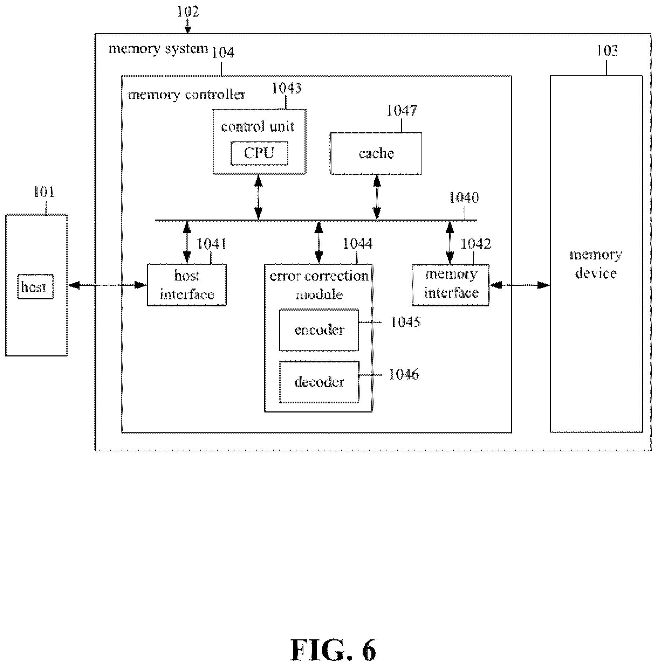

FIG. 6 is a schematic diagram of a system including a host and a memory system according to an implementation of the present disclosure. As shown in FIG. 6, the memory system 102 is connected to the host 101, and the memory system 102 may include a memory controller 104 and a memory device 103, the memory controller 104 is configured to control the memory device 103 to perform operations such as read, write, and erase operations, and the memory controller 104 and the memory device 103 may be coupled in any suitable manner. The memory controller 104 may include a host interface (I/F) 1041, a memory interface (I/F) 1042, a control unit 1043, an error correction module 1044, a cache 1047, and a bus 1040. The host interface 1041 is a connection interface between the connection host 101 and the memory controller 104, and the host interface 1041 allows the host 101 and the memory controller 104 to communicate according to a specific protocol, send read and write requests, and perform other operations. The memory interface 1042 is a connection interface between the memory controller 104 and the memory device 103, and the memory interface 1042 is configured to implement data transfer between the memory controller 104 and the memory device 103. The control unit 1043 is configured to control the memory system 102 as a whole.

In some implementations, the control unit 1043 may include one or more units having a logical operation capability, for example, a central processing unit (CPU) and/or a micro controller unit (MCU).

In some implementations, the cache 1047 is configured to cache data, and may be a volatile memory device, such as a Static Random Access Memory (SRAM) and/or a Dynamic Random Access Memory (DRAM), which has a relatively fast read/write speed.

In some implementations, the error correction module 1044 may be configured to encode and decode data in the memory system using error correction code techniques. Specifically, the error correction module 1044 may comprise an encoder 1045 and a decoder 1046, wherein the encoder 1045 may be configured to encode the data to be written into the memory device in a write operation; the decoder 1046 may be configured to decode codewords to be decoded in the read data in a read operation.

In some implementations, in the process of decoding codewords to be decoded in the read data by using the decoder 1046, a flipping threshold is monotonically decreased to a certain level with the increase of the number of iterations, and is maintained at the certain level, and the decoding performance also needs to be improved. In this regard, the present disclosure provides the following implementations.

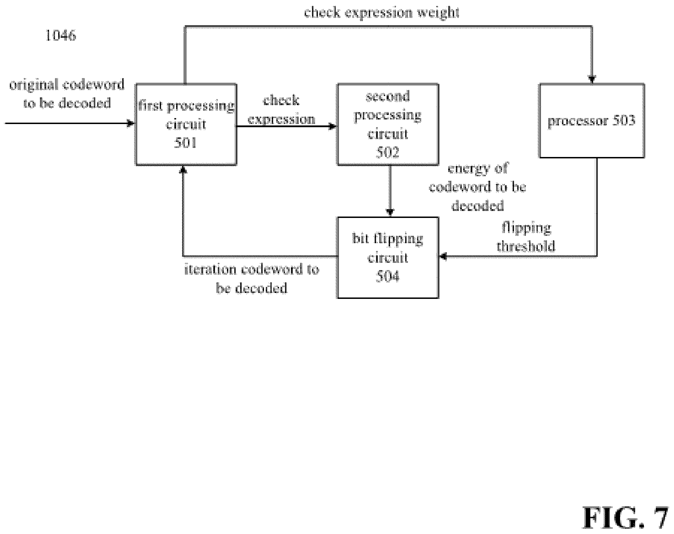

The present disclosure provides a decoder, as shown in FIG. 7, the decoder includes a first processing circuit 501, a second processing circuit 502, a processor 503, and a bit flipping circuit 504, wherein the first processing circuit 501 is configured to: obtain a check expression and a check expression weight based on a codeword to be decoded in a current iteration and a check matrix; the second processing circuit 502 is configured to: obtain energy of the codeword to be decoded in the current iteration based on the check matrix, the check expression, and a flipping state of the codeword to be decoded in the current iteration; the processor 503 is configured to: determine a flipping threshold in the current iteration based on a changing state of the check expression weight; and the bit flipping circuit 504 is configured to: output a codeword to be decoded in a next iteration based on a comparison result of the energy of the codeword to be decoded in the current iteration and the flipping threshold in the current iteration determined by the processor 503.

In the implementation of the present disclosure, the flipping threshold is updated in each iteration, the flipping threshold in the current iteration can be determined based on the changing state of the check expression weight, and the codeword to be decoded in the next iteration is output based on the determined flipping threshold in the current iteration and the energy of the codeword to be decoded in the current iteration, so that setting of the flipping threshold in the current iteration is more reasonable, thereby decoding performance can be improved, and decoding time is reduced.

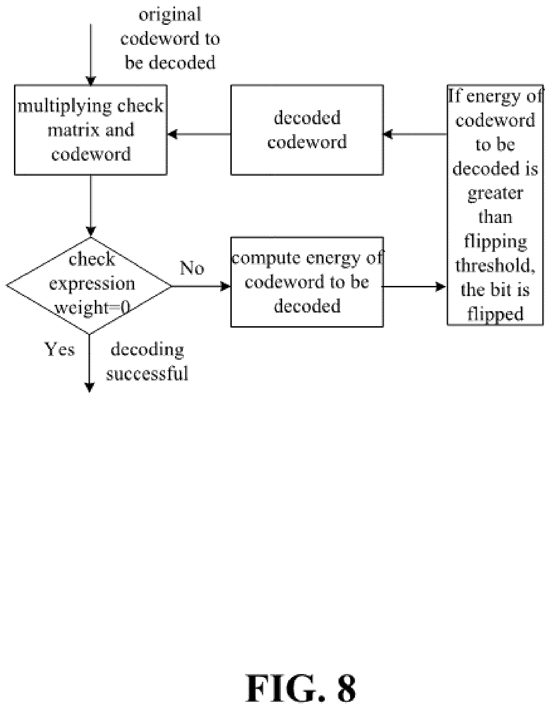

FIG. 8 is a flowchart of a decoding process according to an implementation of the present disclosure. Referring to FIG. 8, a process of decoding by using a decoder in an implementation of the present disclosure includes: multiplying a check matrix and an original codeword to be decoded to obtain a check expression, each bit in the check expression represents a result of check equation parity check, where 0 represents pass, and 1 represents a check error. The number of bits of 1 in the check expression is calculated to obtain the check expression weight, the original codeword to be decoded herein may be a vector. If each bit in the check expression is 0, the check expression weight is 0, the decoding is successful, and the original codeword to be decoded is output as the final decoded codeword. If a bit in the check expression is 1, the check expression weight is not 0, and iteration is needed: the original codeword to be decoded is used as a codeword to be decoded in the first iteration, energy of the original codeword to be decoded is calculated in the first iteration, the energy of the original codeword to be decoded may be understood as energy of each bit in the original codeword to be decoded, and the energy of the original codeword to be decoded is compared with a flipping threshold. If the energy of the bit in the original codeword to be decoded is greater than the flipping threshold, the bit is flipped, and if the energy of the bit in the original codeword to be decoded is less than or equal to the flipping threshold, the bit is kept unchanged, and then a decoded codeword in the first iteration is obtained. The check matrix is multiplied by the decoded codeword in the first iteration to obtain a check expression and a check expression weight, if the check expression weight is 0, the decoding is successful, the decoded codeword in the first iteration is output as the final decoded codeword, if the check expression weight is not 0, the second iteration is performed, and the codeword to be decoded in the second iteration is the decoded codeword in the first iteration. The process of each iteration is similar, and details are not described herein. When the check expression weight is 0 in a certain iteration, the decoding ends, otherwise, the next iteration is performed.

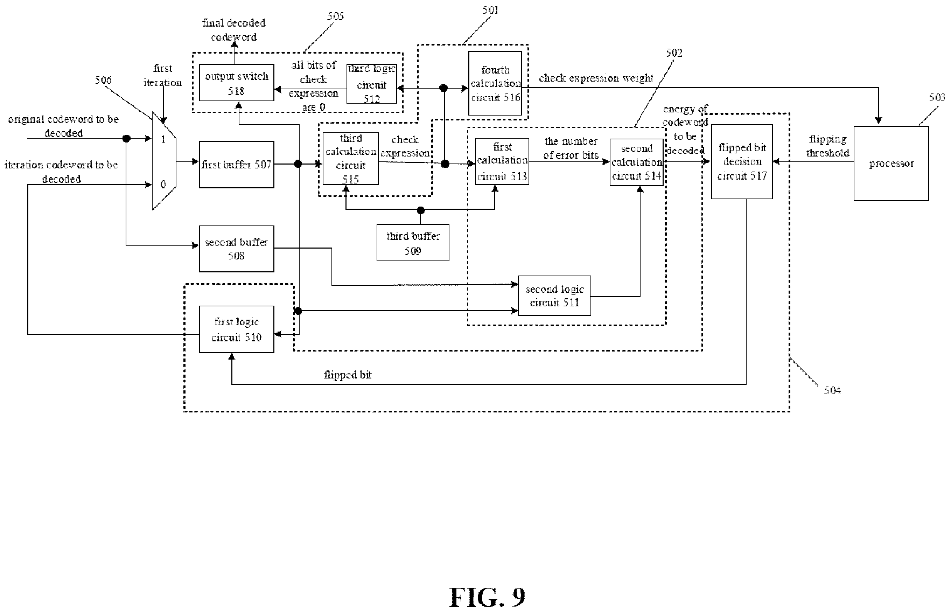

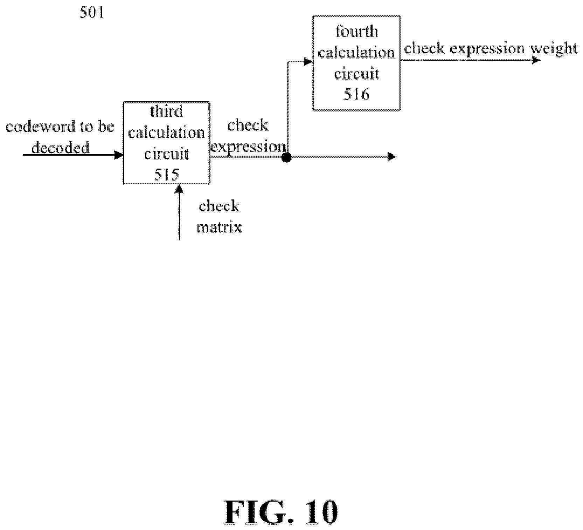

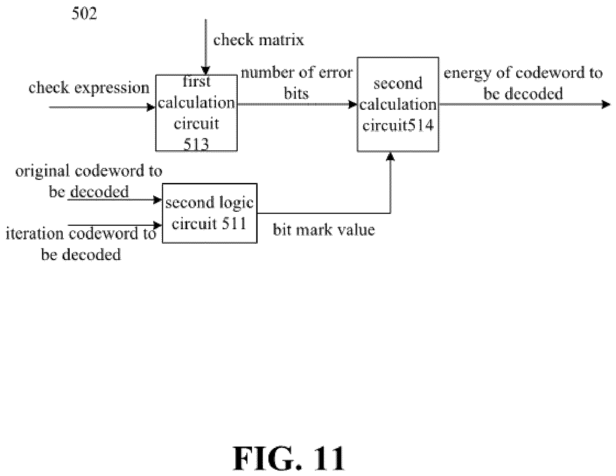

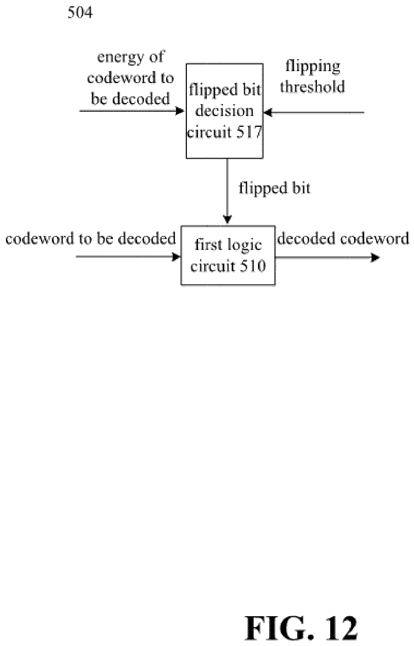

FIG. 9 is a schematic structural diagram of a decoder according to an implementation of the present disclosure; FIG. 10 is a schematic structural diagram of a first processing circuit according to an implementation of the present disclosure; FIG. 11 is a schematic structural diagram of a second processing circuit according to an implementation of the present disclosure; and FIG. 12 is a schematic structural diagram of a bit flipping circuit according to an implementation of the present disclosure. The foregoing decoding process is further described below with reference to FIG. 9 to FIG. 12.

Referring to FIG. 9, the decoder further includes a selector 506, a first buffer 507, and a second buffer 508. The selector 506 may select one of the original codeword to be decoded and an iteration codeword to be decoded as the output based on whether a current iteration is the first iteration. If the current iteration is the first iteration, the selector 506 selects the original codeword to be decoded as the output, and if the current iteration is not the first iteration, the selector 506 selects the iteration codeword to be decoded as the output. The iteration codeword to be decoded herein is a decoded codeword in the previous iteration. The codeword output from the selector 506 is buffered in the first buffer 507, and the original codeword to be decoded is buffered in the second buffer 508.

In some implementations, the first processing circuit 501 is configured to: perform a third calculation on a codeword to be decoded in the current iteration and the check matrix to obtain the check expression; and calculate the number of bits of 1 in the check expression to obtain the check expression weight.

Referring to FIG. 9 and FIG. 10, the first processing circuit 501 includes a third calculation circuit 515 and a fourth calculation circuit 516, where the third calculation circuit 515 is connected to the first buffer 507, and the fourth calculation circuit 516 is connected to the third calculation circuit 515. In some specific examples, the third calculation circuit 515 may include a matrix multiplier, and the fourth calculation circuit 516 may include an adder. The decoder further includes a third buffer 509, where the check matrix is buffered in the third buffer 509, and the third buffer 509 is connected to the third calculation circuit 515. The third calculation circuit 515 receives the codeword to be decoded in the current iteration in the first buffer 507 and the check matrix in the third buffer 509, and the third calculation circuit 515 multiplies the check matrix with the codeword to be decoded to obtain the check expression. In an implementation of the present disclosure, the check expression may be a vector, and each element in the resulting vector may be obtained by a corresponding multiply-add operation, and the addition operation is modulo 2 addition (1 + 1 = 0). The fourth calculation circuit 516 calculates the number of bits of 1 in the check expression to obtain the check expression weight.

In some implementations, referring to FIG. 9, the decoder further includes: an output circuit 505, configured to output the codeword to be decoded in the current iteration as a final decoded codeword according to each bit of the check expression in the current iteration being 0.

In some specific examples, referring to FIG. 9, the output circuit 505 includes a third logic circuit 512 and an output switch 518. The third logic circuit 512 is connected to the third calculation circuit 515, and the output switch 518 is connected to both the third logic circuit 512 and the first buffer 507. The third logic circuit 512 may specifically be an OR gate, and whether each bit in the check expression is 0 may be determined by the third logic circuit 512. The output switch 518 may enable the output switch 518 to be closed based on each bit in the check expression being 0, so that the codeword to be decoded of the current iteration buffered by the first buffer 507 is output as the final codeword. The output switch 518 may also enable the output switch 518 to be open based on a bit in the check expression being 1. It should be noted that, the third logic circuit 512 may further be another logic gate combination that implements the same function.

In some implementations, the second processing circuit 502 is specifically configured to: perform a first calculation on the check expression and the check matrix to obtain the number of errors corresponding to each bit in the codeword to be decoded in the current iteration; obtain a mark value corresponding to each bit in the codeword to be decoded in the current iteration, according to a flipping state of each bit; and perform a second calculation on the number of errors corresponding to each bit in the codeword to be decoded in the current iteration and the mark value to obtain energy of the codeword to be decoded in the current iteration.

Referring to FIG. 9 and FIG. 11, the second processing circuit 502 may specifically include a first calculation circuit 513, a second calculation circuit 514, and a second logic circuit 511, where the first calculation circuit 513 may be connected to both the third calculation circuit 515 and the third buffer 509, and the second logic circuit 511 may be connected to both the first buffer 507 and the second buffer 508. The first calculation circuit 513 performs, for each bit position, a calculation based on the check matrix and the check expression to obtain a vector of numbers of errors, each element of which is the number of check equations in error associated with the corresponding bit in the codeword to be decoded in the current iteration.. The second logic circuit 511 may be an XOR gate, and the second logic circuit 511 may determine whether each bit of the codeword to be decoded in the current iteration is flipped based on the codeword to be decoded in the current iteration buffered in the first buffer 507 and the original codeword to be decoded buffered in the second buffer 508, for example: if a certain bit in the codeword to be decoded in the current iteration is the same as the bit in the original codeword to be decoded, the bit is not flipped, resulting in a mark value of the bit being obtained as 0; and if a certain bit in the codeword to be decoded in the current iteration is different from the bit in the original codeword to be decoded, the bit is flipped, resulting in the mark value of the bit being obtained as 1. It should be noted that, the second logic circuit 511 may further be another logic gate combination that implements the same function.

Continuing referring to FIG. 9 and FIG. 11, the second calculation circuit 514 is connected to both the first calculation circuit 513 and the second logic circuit 511. The second calculation circuit 514 obtains energy of the codeword to be decoded in the current iteration based on the number of errors corresponding to each bit in the codeword to be decoded in the current iteration obtained by the first calculation circuit 513 and the mark value corresponding to each bit in the codeword to be decoded in the current iteration obtained by the second logic circuit 511, where the energy of the codeword to be decoded may be understood as the energy corresponding to each bit in the codeword to be decoded. Specifically, the second calculation circuit 514 adds the number of errors corresponding to each bit in the codeword to be decoded in the current iteration to the mark value of the corresponding bit, so as to obtain the energy of each bit in the codeword to be decoded in the current iteration.

In some implementations, the bit flipping circuit 504 is configured to: compare the energy of each bit in the codeword to be decoded in the current iteration to the flipping threshold in the current iteration; flip the bit according to the energy of the bit being greater than the flipping threshold in the current iteration, or keep the bit unchanged according to the energy of the bit being less than or equal to the flipping threshold in the current iteration, to obtain a decoded codeword in the current iteration; and output the decoded codeword in the current iteration as the codeword to be decoded in the next iteration.

Referring to FIG. 9 and FIG. 12, the bit flipping circuit 504 includes a flip bit decision circuit 517 and a first logic circuit 510, wherein the flip bit decision circuit 517 is connected to the second calculation circuit 514, the processor 503 and the first logic circuit 510, and the first logic circuit 510 is connected to the first buffer 507 and the selector 506. The flip bit decision circuit 517 compares the energy of each bit in the codeword to be decoded in the current iteration to the flipping threshold in the current iteration. In some specific examples, if energy of a bit in the codeword to be decoded in the current iteration is greater than the flipping threshold, a flipping identification value of the bit is counted as 1, and if energy of a bit in the codeword to be decoded in the current iteration is less than or equal to the flipping threshold, the flipping identification value of the bit is counted as 0, the first logic circuit 510 may be an XOR gate, and the first logic circuit 510 performs an XOR operation on each bit in the codeword to be decoded in the current iteration and the flipping identification value of the corresponding bit, so as to obtain a decoded codeword in the current iteration. In some other examples, if the energy of the bit in the codeword to be decoded in the current iteration is greater than the flipping threshold, the flipping identification value of the bit is counted as 0, and if the energy of the bit in the codeword to be decoded in the current iteration is less than or equal to the flipping threshold, the flipping identification value of the bit is counted as 1, the first logic circuit 510 may be a XNOR gate, and the first logic circuit 510 performs a XNOR operation on each bit in the codeword to be decoded in the current iteration and the flipping identification value of the corresponding bit, so as to obtain the decoded codeword in the current iteration, that is, the codeword to be decoded in FIG. 9. It should be noted that, the first logic circuit 510 may also be other combinations of logic gates that implement the same function.

The flipping threshold in the current iteration in the implementations of the present disclosure may be obtained by the processor 503. The processor 503 herein may be a control unit in a memory controller, or may be a hardware processor independent of a control unit of a memory system.

In some implementations, the processor 503 is configured to: determine that the flipping threshold in the current iteration is less than the flipping threshold in a previous iteration, based on the check expression weight decreasing sequentially in the current iteration and at least two previous iterations; or determine that the flipping threshold in the current iteration is greater than the flipping threshold in the previous iteration, based on the check expression weight increasing sequentially in the current iteration and at least two previous iterations; or determine that the flipping threshold in the current iteration is equal to the flipping threshold in the previous iteration, based on the check expression weight remaining unchanged or alternating between decreasing and increasing in the current iteration and at least two previous iterations.

In the implementations of the present disclosure, the flipping threshold in the current iteration may be determined based on the changing state of the check expression weight, and the change of the check expression weight herein may only involve two iterations. For example, when only two iterations are involved, the check expression weight of the codeword to be decoded in the current iteration and the check expression weight of a codeword to be decoded in a previous iteration before the current iteration may be compared; and when more than two iterations are involved, the check expression weight of codewords to be decoded in at least two iterations before the current iteration and the check expression weight of the codeword to be decoded in the current iteration may be compared.

In the foregoing implementation, the check expression weight decreasing sequentially in the current iteration and at least two previous iterations may be understood as the check expression weight of the codeword to be decoded in the current iteration being less than the check expression weight of a codeword to be decoded in a previous iteration, or the check expression weight decreasing sequentially in at least two iterations before the current iteration and the current iteration. When the check expression weight decreases, it indicates that the number of check equations with check errors in the result of check equation parity check decreases, so that the flipping threshold can be appropriately reduced. The check expression weight increasing sequentially in the current iteration and at least two previous iterations may be understood as the check expression weight of the codeword to be decoded in the current iteration being greater than the check expression weight of a codeword to be decoded in a previous iteration, or the check expression weight increasing sequentially in at least two iterations before the current iteration and the current iteration. When the check expression weight increases, the number of check equations with check errors in the result of check equation parity check increases, so that the flipping threshold can be appropriately increased. The check expression weight remaining unchanged or alternating between decreasing and increasing in the current iteration and at least two previous iterations can be understood as the check expression weight of the codeword to be decoded in the current iteration being equal to the check expression weight of a codeword to be decoded in at least one iteration before the current iteration, or the check expression weight being not monotonically increasing or monotonically decreasing in at least two iterations before the current iteration and the current iteration.

It may be understood that, in the foregoing implementation, whether the flipping threshold in the current iteration is increased, decreased, or unchanged compared to the flipping threshold of the previous iteration is determined, based on the specific change of the check expression weight, so that the flipping threshold does not remain unchanged after decreasing monotonically to a certain value as the number of iterations increases, and may be in a wavy shape, the flipping threshold is increased, decreased, or unchanged in the entire iteration process, and the specific setting of the flipping threshold is correspondingly associated with the change of the check expression weight, so that the setting of the flipping threshold is more reasonable, the decoding performance can be improved, and the decoding time is reduced.

In some implementations, the processor 503 is configured to: determine the flipping threshold in the current iteration based on the changing state of the check expression weight and the maximum energy of a codeword to be decoded in a previous iteration.

As described in the foregoing implementation, each bit in the codeword to be decoded has corresponding energy, and the maximum energy of the codeword to be decoded herein may be understood as the energy of the bit with the largest energy among the plurality of bits of the codeword to be decoded.

In the foregoing implementation, the maximum energy of the codeword to be decoded in the previous iteration and the changing state of the check expression weight may be further taken into account to determine the flipping threshold in the current iteration, so that the setting of the flipping threshold is more reasonable, thereby further improving the decoding performance and reducing the decoding time.

In some implementations, the processor 503 is configured to: determine that the flipping threshold in the current iteration is less than the flipping threshold in a previous iteration, based on the check expression weight decreasing sequentially in the current iteration and at least two previous iterations and the maximum energy of the codeword to be decoded in the previous iteration being less than a sum of the flipping threshold of the previous iteration and a step size; or determine that the flipping threshold in the current iteration is greater than the flipping threshold in the previous iteration, based on the check expression weight increasing sequentially in the current iteration and at least two previous iterations or the maximum energy of the codeword to be decoded in the previous iteration being greater than or equal to the sum of the flipping threshold of the previous iteration and the step size; or determine that the flipping threshold in the current iteration is equal to the flipping threshold in the previous iteration, based on the check expression weight remaining unchanged or alternating between decreasing and increasing in the current iteration and at least two previous iterations.

The maximum energy of the codeword to be decoded in the previous iteration being less than a sum of the flipping threshold of the previous iteration and a step size may be understood as that the maximum energy of the codeword to be decoded in the previous iteration is smaller. The sum of the maximum energy of the codeword to be decoded in the previous iteration being greater than or equal to the sum of the flipping threshold of the previous iteration and the step size may be understood as that the maximum energy of the codeword to be decoded in the previous iteration is larger. In implementations of the present disclosure, when the check expression weight is increased and the maximum energy of the codeword to be decoded in the previous iteration is larger, if the flipping threshold is decreased, it will cause some bits to be flipped unnecessarily. When the check expression weight is decreased and the maximum energy of the codeword to be decoded in the previous iteration is smaller, if the flipping threshold is increased, it will cause some bits not to be flipped necessarily. According to implementations of the present disclosure, the change trend of the flipping threshold is specifically set when taking the maximum energy of the codeword to be decoded in the previous iteration and the changing state of the check expression weight into account, so that the decoding performance can be improved, and the decoding time is reduced.

In some implementations, the processor 503 is further configured to: determine the flipping threshold in the current iteration, based on the changing state of the check expression weight, the maximum energy of the codeword to be decoded in the previous iteration, and the relationship between a flipping threshold in the previous iteration and the lower limit of the flipping threshold.

In the foregoing implementations, the maximum energy of the codeword to be decoded in the previous iteration, the changing state of the check expression weight, and the relationship between the flipping threshold in the previous iteration and the lower limit of the flipping threshold may be further taken into account to determine the flipping threshold in the current iteration, so that the setting of the flipping threshold is further optimized, thereby further improving the decoding performance and reducing the decoding time.

In some implementations, the processor 503 is further configured to: determine that the flipping threshold in the current iteration is less than the flipping threshold in the previous iteration, based on the check expression weight decreasing sequentially in the current iteration and at least two previous iterations, and at least one of the following two conditions being satisfied: the maximum energy of the codeword to be decoded in the previous iteration is less than the sum of the flipping threshold of the previous iteration and the step size, and a difference between the flipping threshold in the previous iteration and the step size is greater than the lower limit of the flipping threshold; or determine that the flipping threshold in the current iteration is greater than the flipping threshold in the previous iteration, based on the check expression weight increasing sequentially in the current iteration and at least two previous iterations, or based on the maximum energy of the codeword to be decoded in the previous iteration being greater than or equal to the sum of the flipping threshold of the previous iteration and the step size and the flipping threshold in the previous iteration being the lower limit of the flipping threshold; or determine that the flipping threshold in the current iteration is equal to the flipping threshold in the previous iteration, based on the check expression weight remaining unchanged or alternating between decreasing and increasing in the current iteration and at least two previous iterations.

In the foregoing implementation, when the difference between the flipping threshold in the previous iteration and the step size is greater than the lower limit of the flipping threshold, it indicates that the flipping threshold in the previous iteration is greater than the lower limit of the flipping threshold, and differs from the lower limit of the flipping threshold to some extent, and the checking weight decreases sequentially, so that the flipping threshold in the current iteration may be reduced, and specifically, the flipping threshold in the current iteration may be set as the flipping threshold of the previous iteration minus the step size. When the maximum energy of the codeword to be decoded in the previous iteration is greater than or equal to the sum of the flipping threshold of the previous iteration and the step size and the flipping threshold of the previous iteration is the lower limit of the flipping threshold, it indicates that the maximum energy of the codeword to be decoded in the previous iteration is larger, and when the flipping threshold in the previous iteration is the lower limit of the flipping threshold, if the flipping threshold is reduced or unchanged, it will cause some bits in the codeword to be decoded to be flipped unnecessarily, and the flipping threshold in the current iteration may be set as the flipping threshold of the previous iteration plus the step size.

In some implementations, the processor 503 is further configured to: determine that the flipping threshold in the current iteration is equal to the lower limit of the flipping threshold, based on the check expression weight decreasing sequentially in the current iteration and at least two previous iterations, and the maximum energy of the codeword to be decoded in the previous iteration being less than the sum of the flipping threshold of the previous iteration and the step size, and the difference between the flipping threshold in the previous iteration and the step size being less than the lower limit of the flipping threshold; or determine that the flipping threshold in the current iteration is equal to the upper limit of the flipping threshold, based on the check expression weight increasing sequentially in the current iteration and at least two previous iterations, and the sum of the flipping threshold of the previous iteration and the step size being greater than the upper limit of the flipping threshold.

In the foregoing implementations, when the difference between the flipping threshold in the previous iteration and the step size is less than the lower limit of the flipping threshold, if the flipping threshold in the current iteration is the flipping threshold of the previous iteration minus the step size, it will cause the flipping threshold in the current iteration to be less than the lower limit of the flipping threshold, so that the flipping threshold in the current iteration is directly equal to the lower limit of the flipping threshold. When the sum of the flipping threshold of the previous iteration and the step size is greater than the upper limit of the flipping threshold, if the flipping threshold in the current iteration is the flipping threshold of the previous iteration plus the step size, it will cause the flipping threshold in the current iteration to be greater than the upper limit of the flipping threshold, so that the flipping threshold in the current iteration is directly equal to the upper limit of the flipping threshold. In this way, the flipping threshold in the current iteration is within the upper limit and the lower limit of the flipping threshold.

In some implementations, the processor 503 is further configured to: determine the flipping threshold in the current iteration, based on the number of flipped bits in the previous iteration.

In some implementations, the processor 503 is configured to: determine that the flipping threshold in the current iteration is less than the flipping threshold in the previous iteration, based on the number of flipped bits in the previous iteration being 0.

In some examples, the flipping threshold in the current iteration may be determined, directly based on the number of flipped bits in the previous iteration, that is, the flipping threshold in the current iteration may be determined based on the number of flipped bits in the previous iteration independently of the changing state of the check expression weight. In some examples, when the number of flipped bits in the previous iteration is not 0, the flipping threshold in the current iteration may be further determined based on the changing state of the check expression weight, the maximum energy of the codeword to be decoded in the previous iteration, and the relationship between the flipping threshold in the previous iteration and the lower limit of the flipping threshold according to the foregoing implementations.

In the foregoing implementations, the flipping threshold in the current iteration may be determined based on the number of flipped bits in the previous iteration. The number of flipped bits in the previous iteration herein may be understood as the number of bits flipped in the previous iteration. When the number of flipped bits in the previous iteration is 0, that is, all bits of the codeword to be decoded in the previous iteration are not flipped, which may be due to flipping threshold being set to be larger, so that the flipping threshold in the current iteration is less than the flipping threshold in the previous iteration. For example, the flipping threshold in the current iteration is set as the flipping threshold of the previous iteration minus the step size but not less than 0.

In some implementations, the processor 503 is configured to: determine a flipping threshold in the first iteration, based on a comparison result of the check expression weight of a codeword to be decoded in the first iteration and an initial check expression weight threshold.

In some implementations, the processor 503 is configured to: determine that the flipping threshold in the first iteration is a first flipping threshold, based on the check expression weight of the codeword to be decoded in the first iteration being greater than or equal to the initial check expression weight threshold; or determine that the flipping threshold in the first iteration is a second flipping threshold, based on the check expression weight of the codeword to be decoded in the first iteration being less than the initial check expression weight threshold; the first flipping threshold being greater than the second flipping threshold.

In the foregoing implementation, the flipping threshold in the first iteration may be determined based on a comparison result of the check expression weight of the codeword to be decoded in the first iteration and the initial check expression weight threshold. When the check expression weight of the codeword to be decoded in the first iteration is greater than or equal to the initial check expression weight threshold, the flipping threshold of the first iteration may be set to be larger. When the check expression weight of the codeword to be decoded in the first iteration is less than the initial check expression weight threshold, the flipping threshold of the first iteration may be set to be smaller.

In some implementations, the processor 503 is configured to: determine that the first flipping threshold is the upper limit of the flipping threshold, based on the check expression weight of the codeword to be decoded in the first iteration being greater than or equal to the initial check expression weight threshold; or determine that the second flipping threshold is a difference between the upper limit of the flipping threshold and the step size, based on the check expression weight of the codeword to be decoded in the first iteration being less than the initial check expression weight threshold, and update the upper limit of the flipping threshold to be the second flipping threshold.

In the implementations of the present disclosure, the values of the upper limit, the lower limit of the flipping threshold, the step size and the initial check expression weight threshold may be obtained through tests, and may be pre-configured by the system in the decoding process. The upper limit, the lower limit of the flipping threshold, the step size, and the initial check expression weight threshold may be related to factors such as column weight of the check matrix. In the implementations of the present disclosure, the initial check expression weight threshold is configured to determine the flipping threshold of the first iteration. The upper limit of the flipping threshold and the lower limit of the flipping threshold are configured, in general, the flipping threshold may fluctuate within this interval.

In the implementations of the present disclosure, in each iteration, the flipping threshold is determined to remain unchanged or be increased or decreased, according to the changing state of the check expression weight, the maximum energy of the codeword to be decoded in the previous iteration, and the relationship between the flipping threshold in the previous iteration and the lower limit of the flipping threshold, and the flipping threshold of each iteration does not remain unchanged after the flipping threshold is monotonically decreasing, but undulates in a wave-shape.

Based on the above decoder, an implementation of the present disclosure further provides a controller, including: an interface configured to receive read data; the decoder according to any one of the above implementations, configured to decode a codeword to be decoded in the read data.

The controller herein may be the memory controller 104 as shown in FIG. 1 and FIG. 6. The interface herein may be the memory interface 1042 as shown in FIG. 6.

Based on the above decoder, an implementation of the present disclosure further provides a memory system, including: a memory, configured to output read data; the decoder according to any one of the above implementations, configured to decode a codeword to be decoded in the read data.

In some implementations, the memory system further includes an encoder configured to: receive write data and encode the write data; and the memory is further configured to receive the encoded write data.

In some implementations, the memory system includes a controller coupled with the memory, the controller including the decoder and the encoder.

The structure and composition of the memory system herein may be described in detail with reference to FIG. 1 to FIG. 6, and details are not described herein again for brevity. The memory herein may be the memory device 103 shown in FIG. 1 to FIG. 6. The controller herein may be the memory controller 104 as shown in FIG. 1 and FIG. 6.

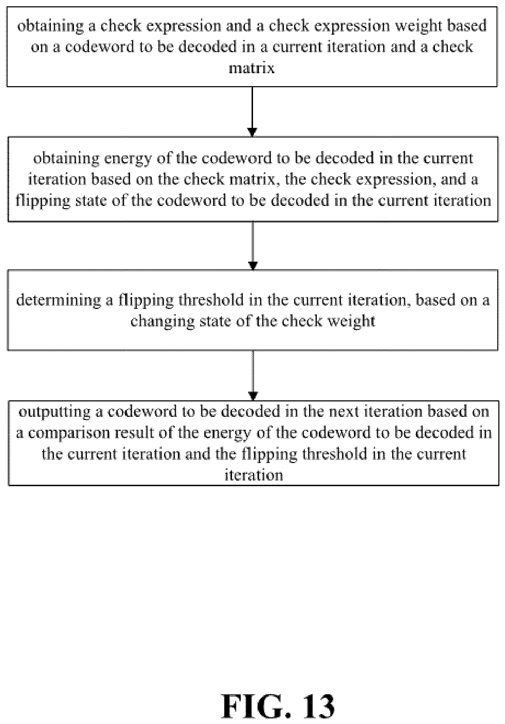

Based on the above decoder, an implementation of the present disclosure further provides a decoding method, as shown in FIG. 13, the decoding method includes: obtaining a check expression and a check expression weight based on a codeword to be decoded in a current iteration and a check matrix; obtaining energy of the codeword to be decoded in the current iteration based on the check matrix, the check expression, and a flipping state of the codeword to be decoded in the current iteration; determining a flipping threshold in the current iteration, based on a changing state of the check expression weight; and outputting a codeword to be decoded in a next iteration based on a comparison result of the energy of the codeword to be decoded in the current iteration and the flipping threshold in the current iteration.

In some implementations, the determining the flipping threshold in the current iteration, based on the changing state of the check expression weight, includes: determining that the flipping threshold in the current iteration is less than the flipping threshold in a previous iteration, based on the check expression weight decreasing sequentially in the current iteration and at least two previous iterations; or determining that the flipping threshold in the current iteration is greater than the flipping threshold in the previous iteration, based on the check expression weight increasing sequentially in the current iteration and at least two previous iterations; or determining that the flipping threshold in the current iteration is equal to the flipping threshold in the previous iteration, based on the check expression weight remaining unchanged or alternating between decreasing and increasing in the current iteration and the at least two previous iterations.

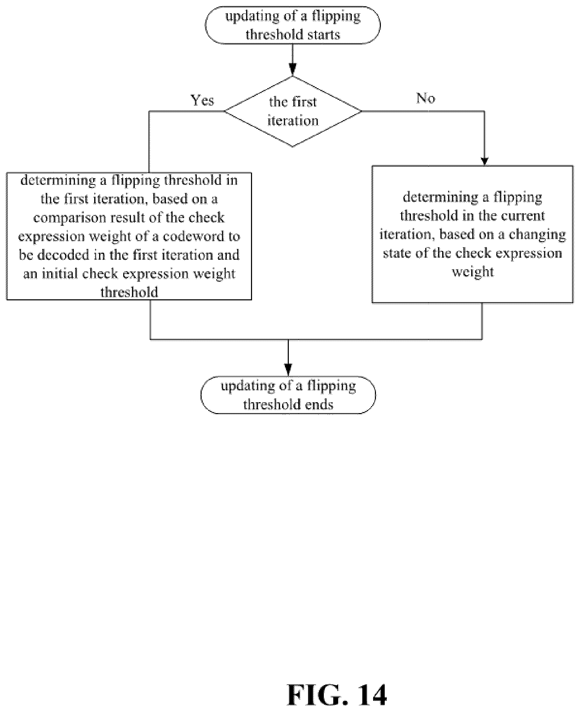

In some implementations, as shown in FIG. 14, the decoding method further includes: determining a flipping threshold in the first iteration, based on a comparison result of the check expression weight of a codeword to be decoded in the first iteration and an initial check expression weight threshold.

In the implementations of the present disclosure, as shown in FIG. 14, updating of the flipping threshold needs to be performed in each iteration, and after the updating of the flipping threshold in each iteration starts, it is determined whether the current iteration is the first iteration; if the current iteration is the first iteration, the flipping threshold in the first iteration may be determined based on a comparison result of the codeword to be decoded in the first iteration (e.g. the original codeword to be decoded) and the initial check expression weight threshold; and if the current iteration is not the first iteration, the flipping threshold in the current iteration may be determined based on the changing state of the check expression weight. After the flipping threshold of the current iteration is determined, the updating of the flipping threshold ends.

In some implementations, the determining the flipping threshold in the first iteration, based on the comparison result of the check expression weight of the codeword to be decoded in the first iteration and the initial check expression weight threshold, includes: determining that the flipping threshold in the first iteration is a first flipping threshold, based on the check expression weight of the codeword to be decoded in the first iteration being greater than or equal to the initial check expression weight threshold; or determining that the flipping threshold in the first iteration is a second flipping threshold, based on the check expression weight of the codeword to be decoded in the first iteration being less than the initial check expression weight threshold; the first flipping threshold being greater than the second flipping threshold.

In some implementations, the determining the flipping threshold in the first iteration, based on the comparison result of the check expression weight of the codeword to be decoded in the first iteration and the initial check expression weight threshold, includes: determining that the first flipping threshold is the upper limit of the flipping threshold, based on the check expression weight of the codeword to be decoded in the first iteration being greater than or equal to the initial check expression weight threshold; or determining that the second flipping threshold is a difference between the upper limit of the flipping threshold and the step size, based on the check expression weight of the codeword to be decoded in the first iteration being less than the initial check expression weight threshold, and updating the upper limit of the flipping threshold to be the second flipping threshold.

In the implementations of the present disclosure, if the current iteration is the first iteration, the flipping threshold in the first iteration may be determined based on a comparison result of the check expression weight of the codeword to be decoded in the first iteration (e.g. the original codeword to be decoded) and the initial check expression weight threshold; and if the current iteration is not the first iteration, the flipping threshold in the current iteration may be comprehensively determined based on a plurality of factors such as the changing state of the check expression weight, the maximum energy of the codeword to be decoded in the previous iteration, and the relationship between the flipping threshold in the previous iteration and the lower limit of the flipping threshold.

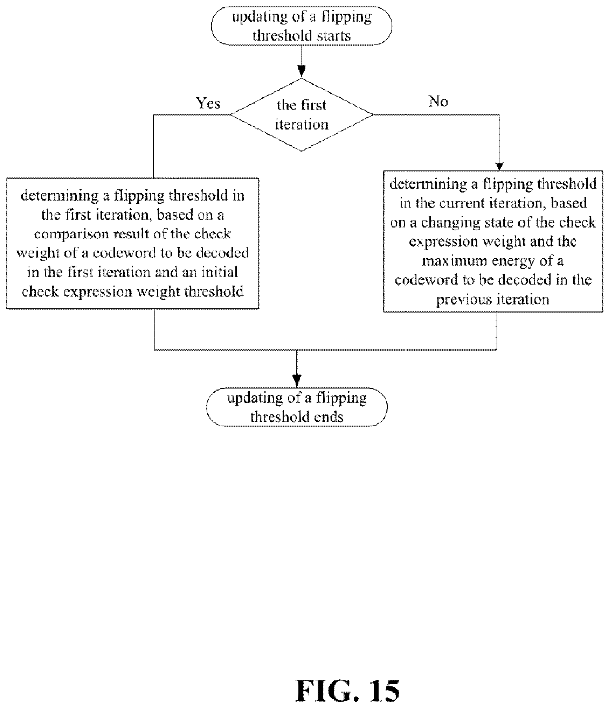

In some implementations, as shown in FIG. 15, the decoding method further includes: determining the flipping threshold in the current iteration based on the changing state of the check expression weight and the maximum energy of the codeword to be decoded in the previous iteration.

In some implementations, the determining the flipping threshold in the current iteration, based on the changing state of the check expression weight and the maximum energy of the codeword to be decoded in the previous iteration, includes: determining that the flipping threshold in the current iteration is less than the flipping threshold in the previous iteration, based on the check expression weight decreasing sequentially in the current iteration and at least two previous iterations and the maximum energy of the codeword to be decoded in the previous iteration being less than a sum of the flipping threshold of the previous iteration and a step size; or determining that the flipping threshold in the current iteration is greater than the flipping threshold in the previous iteration, based on the check expression weight increasing sequentially in the current iteration and the at least two previous iterations or the maximum energy of the codeword to be decoded in the previous iteration being greater than or equal to the sum of the flipping threshold of the previous iteration and the step size; or determining that the flipping threshold in the current iteration is equal to the flipping threshold in the previous iteration based on the check expression weight remaining unchanged or alternating between decreasing and increasing in the current iteration and the at least two previous iterations.

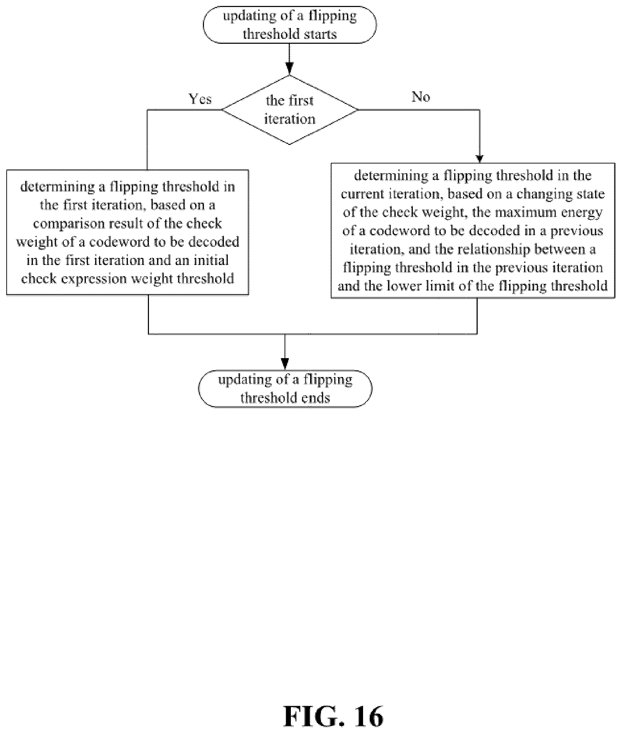

In some implementations, as shown in FIG. 16, the decoding method further includes: determining the flipping threshold in the current iteration, based on the changing state of the check expression weight, the maximum energy of the codeword to be decoded in the previous iteration, and the relationship between the flipping threshold in the previous iteration and the lower limit of the flipping threshold.

In some implementations, the determining the flipping threshold in the current iteration, based on the changing state of the check expression weight, the maximum energy of the codeword to be decoded in the previous iteration, and the relationship between the flipping threshold in the previous iteration and the lower limit of the flipping threshold, includes: determining that the flipping threshold in the current iteration is less than the flipping threshold in the previous iteration, based on the check expression weight decreasing sequentially in the current iteration and the at least two previous iterations, and at least one of the following two conditions being satisfied: the maximum energy of the codeword to be decoded in the previous iteration is less than the sum of the flipping threshold of the previous iteration and the step size, and a difference between the flipping threshold in the previous iteration and the step size is greater than the lower limit of the flipping threshold; or determining that the flipping threshold in the current iteration is greater than the flipping threshold in the previous iteration, based on the check expression weight increasing sequentially in the current iteration and the at least two previous iterations, or based on the maximum energy of the codeword to be decoded in the previous iteration being greater than or equal to the sum of the flipping threshold of the previous iteration and the step size and the flipping threshold in the previous iteration being the lower limit of the flipping threshold; or determining that the flipping threshold in the current iteration is equal to the flipping threshold in the previous iteration, based on the check expression weight remaining unchanged or alternating between decreasing and increasing in the current iteration and the at least two previous iterations.

In some implementations, the determining the flipping threshold in the current iteration, based on the changing state of the check expression weight, the maximum energy of the codeword to be decoded in the previous iteration, and the relationship between the flipping threshold in the previous iteration and the lower limit of the flipping threshold, further includes: determining that the flipping threshold in the current iteration is equal to the lower limit of the flipping threshold, based on the check expression weight decreasing sequentially in the current iteration and the at least two previous iterations, and the maximum energy of the codeword to be decoded in the previous iteration being less than the sum of the flipping threshold of the previous iteration and the step size, and the difference between the flipping threshold in the previous iteration and the step size being less than the lower limit of the flipping threshold; or determining that the flipping threshold in the current iteration is equal to the upper limit of the flipping threshold, based on the check expression weight increasing sequentially in the current iteration and the at least two previous iterations, and the sum of the flipping threshold of the previous iteration and the step size being greater than the upper limit of the flipping threshold.

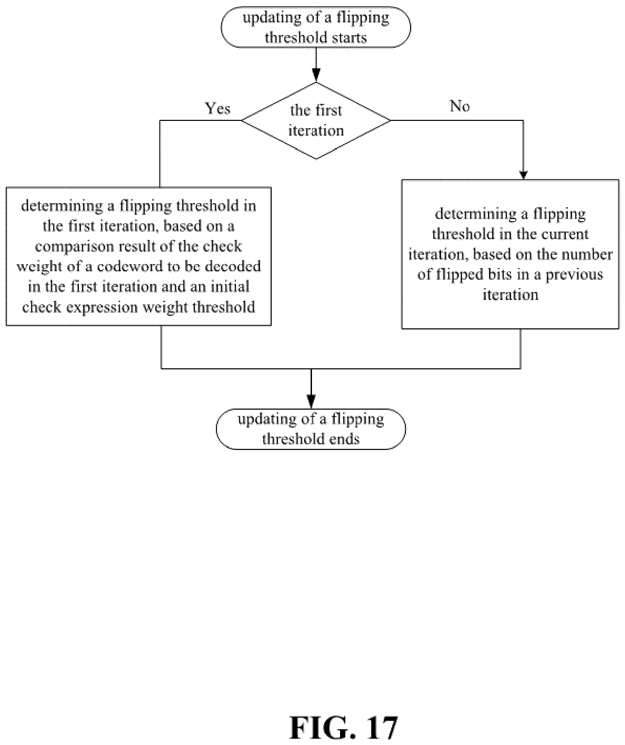

In some implementations, as shown in FIG. 17, the decoding method further includes: determining the flipping threshold in the current iteration, based on the number of flipped bits in the previous iteration.

In some implementations, the determining the flipping threshold in the current iteration, based on the number of flipped bits in the previous iteration, includes: determining that the flipping threshold in the current iteration is less than the flipping threshold in the previous iteration, based on the number of flipped bits in the previous iteration being 0.

In some implementations, the obtaining the energy of the codeword to be decoded in the current iteration based on the check matrix, the check expression, and the flipping state of the codeword to be decoded in the current iteration includes: performing a first calculation on the check expression and the check matrix to obtain the number of errors corresponding to each bit in the codeword to be decoded in the current iteration; obtaining a mark value corresponding to each bit in the codeword to be decoded in the current iteration, according to the flipping state of each bit; and performing a second calculation on the number of errors corresponding to each bit in the codeword to be decoded in the current iteration and the mark value, to obtain the energy of the codeword to be decoded in the current iteration.

In some implementations, the outputting the codeword to be decoded in the next iteration based on the comparison result of the energy of the codeword to be decoded in the current iteration and the flipping threshold in the current iteration includes: comparing the energy of each bit in the codeword to be decoded in the current iteration to the flipping threshold in the current iteration; and flipping the bit according to the energy of the bit being greater than the flipping threshold in the current iteration, or keeping the bit unchanged according to the energy of the bit being less than or equal to the flipping threshold in the current iteration, to obtain a decoded codeword in the current iteration; and outputting the decoded codeword in the current iteration as a codeword to be decoded in the next iteration.

In some implementations, the obtaining the check expression and the check expression weight based on the codeword to be decoded in the current iteration and the check matrix includes: performing a third calculation on the codeword to be decoded in the current iteration and the check matrix, to obtain the check expression; and calculating the number of bits of 1 in the check expression, to obtain the check expression weight.

In some implementations, the decoding method further includes: outputting the codeword to be decoded in the current iteration as a final decoded codeword, according to each bit of the check expression in the current iteration being 0.

Based on the foregoing decoding method, the implementations of the present disclosure further provides an operating method of a memory system, where the operation method includes: reading data by using a memory; and decoding a codeword to be decoded in the read data by using the decoding method according to any one of the foregoing implementations.

The decoding method mentioned in the foregoing implementations has been described in detail in the foregoing implementations of the decoder, and the operating method of the memory system mentioned in the foregoing implementations is described in detail in the foregoing implementations of the memory system, and for brevity, details are not described herein again.

Based on the foregoing decoding method, an implementation of the present disclosure further provides a computer-readable storage medium, where the computer-readable storage medium stores computer programs, and when the computer programs are executed by a processor, the decoding method according to any one of the foregoing implementations is performed.

Here, all or part of the processes in the decoding method in the foregoing implementations may be completed by computer programs for instructing related hardware, and the programs may be stored in computer-readable storage medium, and the programs, when executed, may include processes of the implementations of the foregoing methods. The storage medium may be a magnetic random access memory (FRAM), a read-only memory (ROM), a programmable read-only memory (PROM), an erasable programmable read-only memory (EPROM), an electrically erasable programmable read-only memory (EEPROM), a flash memory, a magnetic surface memory, an optical disk, or a compact disc read-only memory (CD-ROM), and the like; and the storage medium may further include a combination of the foregoing types of memories.

The features disclosed in the several device implementations provided by the present disclosure may be arbitrarily combined without conflict, to obtain a new device implementation.

The methods disclosed in the several method implementations provided by the present disclosure may be arbitrarily combined without conflict, to obtain a new method implementation.

## Claims

1. A decoder (1046) for an error correcting code, comprising: a first processing circuit (501) configured to: obtain a check expression and a check expression weight based on a codeword to be decoded in a current iteration and a check matrix of the error correcting code, wherein
the check expression is obtained by multiplying the check matrix and the codeword to be decoded in the current iteration, each bit in the check expression representing a result of a check equation, wherein the result of the check equation comprises either a pass or a check error;
a second processing circuit (502) configured to: obtain an energy of the codeword to be decoded in the current iteration,
wherein the energy of each bit in the codeword is obtained by adding a number of check errors corresponding to each bit in the codeword to be decoded to a mark value of the corresponding bit, wherein the mark value is obtained as 0 if a respective bit in the codeword to be decoded in the current iteration is the same as the corresponding bit in the original codeword to be decoded in a first iteration, and the mark value is obtained as 1 if a respective bit in the codeword to be decoded is different from the bit in the original codeword to be decoded;
a processor (503) configured to: determine a flipping threshold in the current iteration,
wherein the flipping threshold is determined such that the flipping threshold is within an upper limit and a lower limit; and
the flipping threshold in the current iteration is determined to be equal to the lower limit of the flipping threshold, based on the check expression weight decreasing sequentially in the current iteration and at least two previous iterations, and the maximum energy of the codeword to be decoded in the previous iteration being less than the sum of the flipping threshold of the previous iteration and a step size, and the difference between the flipping threshold in the previous iteration and the step size being less than the lower limit of the flipping threshold, wherein the maximum energy of the codeword corresponds to the energy of the bit with the largest energy among the plurality of bits of the codeword to be decoded; and
a bit flipping circuit (504) configured to:
compare energy of each bit in the codeword to be decoded in the current iteration to the flipping threshold in the current iteration;
flip the bit according to the energy of the bit being greater than the flipping threshold in the current iteration, or keep the bit unchanged according to the energy of the bit being less than or equal to the flipping threshold in the current iteration, to obtain a decoded codeword in the current iteration; and
output the decoded codeword in the current iteration as a codeword to be decoded in a next iteration.

2. The decoder (1046) according to claim 1, wherein the processor (503) is further configured to:
determin the flipping threshold in the current iteration to be less than the flipping threshold in a previous iteration, based on the check expression weight decreasing sequentially in the current iteration and the at least two previous iterations; or
determine the flipping threshold in the current iteration to be greater than the flipping threshold in the previous iteration, based on the check expression weight increasing sequentially in the current iteration and the at least two previous iterations; or
determine the flipping threshold in the current iteration is equal to the flipping threshold in the previous iteration, based on the check expression weight remaining unchanged or alternating between decreasing and increasing in the current iteration and the at least two previous iterations.

3. The decoder (1046) according to claim 1, wherein the processor (503) is further configured to:
determine the flipping threshold in the current iteration to be less than the flipping threshold in the previous iteration, based on the check expression weight decreasing sequentially in the current iteration and the at least two previous iterations and the maximum energy of the codeword to be decoded in the previous iteration being less than a sum of the flipping threshold of the previous iteration and the step size; or
determine the flipping threshold in the current iteration to be greater than the flipping threshold in the previous iteration, based on the check expression weight increasing sequentially in the current iteration and the at least two previous iterations or the maximum energy of the codeword to be decoded in the previous iteration being greater than or equal to the sum of the flipping threshold of the previous iteration and the step size; or
determine the flipping threshold in the current iteration to be equal to the flipping threshold in the previous iteration, based on the check expression weight remaining unchanged or alternating between decreasing and increasing in the current iteration and the at least two previous iterations.

4. The decoder (1046) according to claim 1, wherein the processor (503) is further configured to:
determine the flipping threshold in the current iteration to be less than the flipping threshold in the previous iteration, based on the check expression weight decreasing sequentially in the current iteration and the at least two previous iterations, and at least one of the following two conditions being satisfied: the maximum energy of the codeword to be decoded in the previous iteration is less than a sum of the flipping threshold of the previous iteration and the step size, and a difference between the flipping threshold in the previous iteration and the step size is greater than the lower limit of the flipping threshold; or
determine the flipping threshold in the current iteration to be greater than the flipping threshold in the previous iteration, based on the check expression weight increasing sequentially in the current iteration and the at least two previous iterations, or based on the maximum energy of the codeword to be decoded in the previous iteration being greater than or equal to the sum of the flipping threshold of the previous iteration and the step size and the flipping threshold in the previous iteration being the lower limit of the flipping threshold; or
determine the flipping threshold in the current iteration to be equal to the flipping threshold in the previous iteration, based on the check expression weight remaining unchanged or alternating between decreasing and increasing in the current iteration and the at least two previous iterations.

5. The decoder (1046) according to claim 1, wherein the processor (503) is further configured to:
determine the flipping threshold in the current iteration to be equal to an upper limit of the flipping threshold, based on the check expression weight increasing sequentially in the current iteration and the at least two previous iterations, and the sum of the flipping threshold of the previous iteration and the step size being greater than the upper limit of the flipping threshold.

6. The decoder (1046) according to claim 1, wherein the processor (503) is further configured to:
determine the flipping threshold in the current iteration, based on a number of flipped bits in a previous iteration, wherein the flipping threshold in the current iteration is determined to be less than the flipping threshold in the previous iteration, based on the number of flipped bits in the previous iteration being 0; and
determine a flipping threshold in the e first iteration, based on a comparison result of the check expression weight of the codeword to be decoded in the first iteration and an initial check expression weight threshold; and/or
determine the flipping threshold in the first iteration to be a first flipping threshold, based on the check expression weight of the codeword to be decoded in the first iteration being greater than or equal to the initial check expression weight threshold; or
determine the flipping threshold in the first iteration to be a second flipping threshold, based on the check expression weight of the codeword to be decoded in the first iteration being less than the initial check expression weight threshold, the first flipping threshold being greater than the second flipping threshold.

7. The decoder (1046) according to claim 6, wherein the processor (503) is configured to:
determine the first flipping threshold to be the upper limit of the flipping threshold, based on the check expression weight of the codeword to be decoded in the first iteration being greater than or equal to the initial check expression weight threshold; or
determine the second flipping threshold as the difference between the upper limit of the flipping threshold and the step size, based on the check expression weight of the codeword to be decoded in the first iteration being less than the initial check expression weight threshold, and update the upper limit of the flipping threshold to be the second flipping threshold.

8. The decoder (1046) according to claim 1, wherein the first processing circuit (501) is configured to:
calculate a number of bits of value 1 in the check expression, to obtain the check expression weight.

9. The decoder (1046) according to claim 1, wherein the decoder (1046) further includes:
an output circuit, configured to: output the codeword to be decoded in the current iteration as a final decoded codeword, according to each bit of the check expression in the current iteration being 0.

10. A memory system (102) comprising
a memory, configured to: output read data; and
a decoder (1046) according to any one of the preceding claims.

11. The memory system (102) of claim 10, further including:
an encoder for an error correcting code, configured to: receive write data and encode the write data,
wherein the memory is further configured to: receive the encoded write data.

12. The memory system (102) of claim 11, wherein the memory system (102) includes a controller coupled with the memory, the controller including the decoder (1046) and the encoder.

13. An operating method for a memory system (102), the operating method including:
reading data using a memory; and
decoding a codeword to be decoded in the read data using a decoding method for an error correcting code, the decoding method comprising:
obtaining a check expression and a check expression weight based on a codeword to be decoded in a current iteration and a check matrix of the error correcting code, wherein the check expression is obtained by multiplying the check matrix and the codeword to be decoded in the current iteration, each bit in the check expression representing a result of a check equation, wherein the result of the check equation comprises either a pass or a check error;
obtaining an energy of the codeword to be decoded in the current iteration, wherein the energy of each bit in the codeword is obtained by adding a number of check equations in error corresponding to each bit in the codeword to be decoded to a mark value of the corresponding bit, wherein the mark value is obtained as 0 if a respective bit in the codeword to be decoded in the current iteration is the same as the corresponding bit in the original codeword to be decoded in a first iteration, and the mark value is obtained as 1 if a respective bit in the codeword to be decoded is different from the bit in the original codeword to be decoded;
determining a flipping threshold in the current iteration, wherein the flipping threshold is determined such that the flipping threshold is within an upper limit and a lower limit; and
the flipping threshold in the current iteration is determined to be equal to the lower limit of the flipping threshold, based on the check expression weight decreasing sequentially in the current iteration and at least two previous iterations, and the maximum energy of the codeword to be decoded in the previous iteration being less than the sum of the flipping threshold of the previous iteration and a step size, and the difference between the flipping threshold in the previous iteration and the step size being less than the lower limit of the flipping threshold, wherein the maximum energy of the codeword corresponds to the energy of the bit with the largest energy among the plurality of bits of the codeword to be decoded;
comparing energy of each bit in the codeword to be decoded in the current iteration to the flipping threshold in the current iteration;
flipping the bit according to the energy of the bit being greater than the flipping threshold in the current iteration, or keeping the bit unchanged according to the energy of the bit being less than or equal to the flipping threshold in the current iteration, to obtain a decoded codeword in the current iteration; and
outputting the decoded codeword in the current iteration as a codeword to be decoded in a next iteration.

## Patentansprüche

1. Ein Decoder (1046) für einen Fehlerkorrekturcode, aufweisend: eine erste Verarbeitungsschaltung (501), die ausgebildet ist zum: Ermitteln einer Prüfgleichung und einer Prüfgleichungsgewichtung auf der Grundlage eines in einer aktuellen Iteration zu decodierenden Codeworts und einer Prüfmatrix des Fehlerkorrekturcodes, wobei die Prüfgleichung durch Multiplikation der Prüfmatrix mit dem in der aktuellen Iteration zu decodierenden Codewort ermittelt wird, wobei jedes Bit in der Prüfgleichung ein Ergebnis einer Prüfgleichung darstellt, wobei das Ergebnis der Prüfgleichung entweder ein Bestanden oder einen Prüffehler aufweist;
eine zweite Verarbeitungsschaltung (502), die ausgebildet ist zum: Ermitteln einer Energie des in der aktuellen Iteration zu decodierenden Codeworts, wobei die Energie jedes Bits im Codewort durch Addition einer Anzahl von Prüffehlern, die jedem Bit im zu decodierenden Codewort entsprechen, zu einem Markierungswert des entsprechenden Bits ermittelt wird,
wobei der Markierungswert als 0 ermittelt wird, wenn ein jeweiliges Bit in dem Codewort, das in der aktuellen Iteration zu decodieren ist, mit dem entsprechenden Bit in dem ursprünglichen, in einer ersten Iteration zu decodierenden Codewort übereinstimmt, und wobei der Markierungswert als 1 ermittelt wird, wenn ein jeweiliges Bit in dem zu decodierenden Codewort sich von dem Bit im ursprünglichen, zu decodierenden Codewort unterscheidet; einen Prozessor (503), der ausgebildet ist zum: Ermitteln eines Umschalt-Schwellenwerts in der aktuellen Iteration,
wobei der Umschalt-Schwellenwert so ermittelt wird, dass er zwischen einer Obergrenze und einer Untergrenze liegt; und
wobei der Umschalt-Schwellenwert in der aktuellen Iteration so bestimmt wird, dass er dem unteren Grenzwert des Umschalt-Schwellenwerts entspricht,
basierend darauf, dass die Prüfgleichungsgewichtung in der aktuellen Iteration und in mindestens zwei vorherigen Iterationen sequenziell abnimmt und dass die maximale Energie des in der vorherigen Iteration zu decodierenden Codeworts kleiner ist als die Summe aus dem Umschalt-Schwellenwert der vorherigen Iteration und einer Schrittweite, und dass die Differenz zwischen dem Umschalt-Schwellenwert in der vorherigen Iteration und der Schrittweite kleiner ist als die Untergrenze des Umschalt-Schwellenwerts, wobei die maximale Energie des Codeworts der Energie des Bits mit der größten Energie unter der Mehrzahl von Bits des zu decodierenden Codeworts entspricht; und
eine Bit-Umschalt-Schaltung (504), die ausgebildet ist zum: Vergleichen der Energie jedes Bits in dem in der aktuellen Iteration zu decodierenden Codewort mit dem Umschalt-Schwellenwert in der aktuellen Iteration;
zum Umschalten des Bits, wenn die Energie des Bits größer als der Umschalt-Schwellenwert in der aktuellen Iteration ist, oder zum unveränderten Beibehalten des Bits, wenn die Energie des Bits kleiner oder gleich dem Umschalt-Schwellenwert in der aktuellen Iteration ist, um ein decodiertes Codewort in der aktuellen Iteration zu erhalten; und
zum Ausgeben des decodierten Codeworts in der aktuellen Iteration als ein Codewort, das in einer nächsten Iteration decodiert werden soll.

2. Decoder (1046) nach Anspruch 1, wobei der Prozessor (503) ferner ausgebildet ist zum:
Bestimmen des Umschalt-Schwellenwerts in der aktuellen Iteration so, dass er kleiner ist als der Umschalt-Schwellenwert in einer vorherigen Iteration,
basierend darauf, dass die Prüfgleichungsgewichtung in der aktuellen Iteration und den mindestens zwei vorherigen Iterationen sequenziell abnimmt; oder
Bestimmen des Umschalt-Schwellenwerts in der aktuellen Iteration so, dass er größer ist als der Umschalt-Schwellenwert in der vorherigen Iteration,
basierend darauf, dass die Prüfgleichungsgewichtung in der aktuellen Iteration und den mindestens zwei vorherigen Iterationen sequenziell zunimmt; oder
Bestimmen des Umschalt-Schwellenwerts in der aktuellen Iteration so, dass er gleich dem Umschalt-Schwellenwert in der vorherigen Iteration ist, basierend darauf, dass die Prüfgleichungsgewichtung in der aktuellen Iteration und den mindestens zwei vorherigen Iterationen unverändert bleibt oder zwischen Abnahme und Zunahme wechselt.

3. Decoder (1046) gemäß Anspruch 1, wobei der Prozessor (503) ferner ausgebildet ist zum:
Bestimmen des Umschalt-Schwellenwerts in der aktuellen Iteration so, dass er kleiner ist als der Umschalt-Schwellenwert in der vorherigen Iteration,
basierend darauf, dass die Prüfgleichungsgewichtung in der aktuellen Iteration und den mindestens zwei vorherigen Iterationen sequenziell abnimmt und die maximale Energie des in der vorherigen Iteration zu decodierenden Codeworts kleiner ist als eine Summe aus dem Umschalt-Schwellenwert der vorherigen Iteration und der Schrittgröße; oder
Bestimmen des Umschalt-Schwellenwerts in der aktuellen Iteration so, dass er größer ist als der Umschalt-Schwellenwert in der vorherigen Iteration,
basierend darauf, dass die Prüfgleichungsgewichtung in der aktuellen Iteration und den mindestens zwei vorherigen Iterationen sequenziell zunimmt oder
dass die maximale Energie des in der vorherigen Iteration zu decodierenden Codeworts größer oder gleich der Summe aus dem Umschalt-Schwellenwert der vorherigen Iteration und der Schrittweite ist; oder
Bestimmen des Umschalt-Schwellenwerts in der aktuellen Iteration so, dass er gleich dem Umschalt-Schwellenwert der vorherigen Iteration ist, basierend darauf, dass die Prüfgleichungsgewichtung in der aktuellen Iteration und den mindestens zwei vorherigen Iterationen unverändert bleibt oder zwischen Abnahme und Zunahme wechselt.

4. Decoder (1046) nach Anspruch 1, wobei der Prozessor (503) ferner ausgebildet ist zum:
Bestimmen des Umschalt-Schwellenwerts in der aktuellen Iteration so, dass er kleiner ist als der Umschalt-Schwellenwert in der vorherigen Iteration,
basierend darauf, dass die Prüfgleichungsgewichtung in der aktuellen Iteration und den mindestens zwei vorherigen Iterationen sequenziell abnimmt und
mindestens eine der folgenden beiden Bedingungen erfüllt ist: die maximale Energie des in der vorherigen Iteration zu decodierenden Codeworts ist kleiner als die Summe aus dem Umschalt-Schwellenwert der vorherigen Iteration und der Schrittweite, und eine Differenz zwischen dem Umschalt-Schwellenwert in der vorherigen Iteration und der Schrittweite ist größer als die Untergrenze des Umschalt-Schwellenwerts; oder
Bestimmen des Umschalt-Schwellenwerts in der aktuellen Iteration so, dass er größer ist als der Umschalt-Schwellenwert in der vorherigen Iteration,
basierend darauf, dass die Prüfgleichungsgewichtung in der aktuellen Iteration und den mindestens zwei vorherigen Iterationen sequenziell ansteigt, oder
basierend darauf, dass die maximale Energie des in der vorherigen Iteration zu decodierenden Codeworts größer oder gleich der Summe aus dem Umschalt-Schwellenwert der vorherigen Iteration und der Schrittweite ist und
der Umschalt-Schwellenwert in der vorherigen Iteration die Untergrenze des Umschalt-Schwellenwerts ist; oder
Bestimmen des Umschalt-Schwellenwerts in der aktuellen Iteration so, dass er dem Umschalt-Schwellenwert der vorherigen Iteration entspricht, basierend darauf, dass die Prüfgleichungsgewichtung in der aktuellen Iteration und den mindestens zwei vorherigen Iterationen unverändert bleibt oder zwischen Abnahme und Zunahme wechselt.

5. Decoder (1046) nach Anspruch 1, wobei der Prozessor (503) ferner ausgebildet ist zum:
Bestimmen des Umschalt-Schwellenwerts in der aktuellen Iteration so, dass er einer Obergrenze des Umschalt-Schwellenwerts entspricht, basierend darauf, dass die Prüfgleichungsgewichtung in der aktuellen Iteration und den mindestens zwei vorherigen Iterationen sequenziell ansteigt und die Summe aus dem Umschalt-Schwellenwert der vorherigen Iteration und der Schrittweite größer ist als die Obergrenze des Umschalt-Schwellenwerts.

6. Decoder (1046) nach Anspruch 1, wobei der Prozessor (503) ferner ausgebildet ist zum:
Bestimmen des Umschalt-Schwellenwerts in der aktuellen Iteration auf der Grundlage einer Anzahl von umgeschalteten Bits in einer vorherigen Iteration, wobei der Umschalt-Schwellenwert in der aktuellen Iteration so bestimmt wird, dass er kleiner als der Umschalt-Schwellenwert in der vorherigen Iteration ist, basierend darauf, dass die Anzahl der umgeschalteten Bits in der vorherigen Iteration 0 ist; und
Bestimmen eines Umschalt-Schwellenwerts in der ersten Iteration, basierend auf einem Vergleichsergebnis der Prüfgleichungsgewichtung des in der ersten Iteration zu decodierenden Codeworts mit einem anfänglichen Schwellenwert für die Prüfgleichungsgewichtung; und/oder
Bestimmen, dass der Umschalt-Schwellenwert in der ersten Iteration ein erster Umschalt-Schwellenwert ist, basierend darauf, dass die Prüfgleichungsgewichtung des in der ersten Iteration zu decodierenden Codeworts größer als oder gleich dem anfänglichen Schwellenwert für die Prüfgleichungsgewichtung ist; oder
Bestimmen, dass der Umschalt-Schwellenwert in der ersten Iteration ein zweiter Umschalt-Schwellenwert ist, basierend darauf, dass die Prüfgleichungsgewichtung des in der ersten Iteration zu decodierenden Codeworts kleiner als der anfängliche Schwellenwert für die Prüfgleichungsgewichtung ist, wobei der erste Umschalt-Schwellenwert größer als der zweite Umschalt-Schwellenwert ist.

7. Decoder (1046) nach Anspruch 6, wobei der Prozessor (503) ferner ausgebildet ist zum:
Bestimmen, dass der erste Umschalt-Schwellenwert eine Obergrenze des Umschalt-Schwellenwert ist, basierend darauf, dass die Prüfgleichungsgewichtung des in der ersten Iteration zu decodierenden Codeworts größer als oder gleich dem anfänglichen Schwellenwert für die Prüfgleichungsgewichtung ist; oder
Bestimmen, dass der zweite Umschalt-Schwellenwert die Differenz zwischen der Obergrenze des Umschalt-Schwellenwerts und der Schrittweite ist, basierend darauf, dass die Prüfgleichungsgewichtung des in der ersten Iteration zu decodierenden Codeworts kleiner als der anfängliche Schwellenwert für die Prüfgleichungsgewichtung ist, und
Aktualisieren der Obergrenze des Umschalt-Schwellenwerts auf den zweiten Umschalt-Schwellenwert.

8. Decoder (1046) nach Anspruch 1, wobei die erste Verarbeitungsschaltung (501) ausgebildet ist zum:
Berechnen der Anzahl der Bits mit dem Wert 1 in der Prüfgleichung, um die Prüfgleichungsgewichtung zu ermitteln.

9. Decoder (1046) nach Anspruch 1, wobei der Decoder (1046) ferner aufweist: eine Ausgangsschaltung, die ausgebildet ist zum: Ausgeben des in der aktuellen Iteration zu decodierenden Codeworts als endgültiges decodiertes Codewort, wobei jedes Bit der Prüfgleichung in der aktuellen Iteration den Wert 0 hat.

10. Ein Speichersystem (102), aufweisend:
einen Speicher, der ausgebildet ist zum: Ausgeben von Lesedaten; und
einen Decoder (1046) gemäß einem der vorstehenden Ansprüche.

11. Speichersystem (102) nach Anspruch 10, das ferner aufweist:
einen Encoder für einen Fehlerkorrekturcode, der ausgebildet ist zum Empfangen von Schreibdaten und Codieren der Schreibdaten,
wobei der Speicher ferner ausgebildet ist zum: Empfangen der codierten Schreibdaten.

12. Speichersystem (102) nach Anspruch 11, wobei das Speichersystem (102) eine mit dem Speicher gekoppelte Steuerung aufweist, wobei die Steuerung den Decoder (1046) und den Encoder aufweist.

13. Ein Betriebsverfahren für ein Speichersystem (102), wobei das Betriebsverfahren folgende Schritte aufweist:
Lesen von Daten unter Verwendung eines Speichers; und
Decodieren eines in den gelesenen Daten enthaltenen Codeworts unter Verwendung eines Decodierverfahrens für einen Fehlerkorrekturcode, wobei das Decodierverfahren folgende Schritte aufweist:
Ermitteln einer Prüfgleichung und einer Prüfgleichungsgewichtung basierend auf einem in einer aktuellen Iteration zu decodierenden Codewort und auf einer Prüfmatrix des Fehlerkorrekturcodes, wobei die Prüfgleichung durch Multiplikation der Prüfmatrix mit dem in der aktuellen Iteration zu decodierenden Codewort ermittelt wird, wobei jedes Bit in der Prüfgleichung ein Ergebnis einer Prüfgleichung darstellt, wobei das Ergebnis der Prüfgleichung entweder ein Bestanden oder einen Prüffehler aufweist;
Ermitteln einer Energie des in der aktuellen Iteration zu decodierenden Codeworts, wobei die Energie jedes Bits im Codewort durch Addition einer Anzahl von fehlerhaften Prüfgleichungen, die jedem Bit im zu decodierenden Codewort entsprechen, zu einem Markierungswert des entsprechenden Bits ermittelt wird, wobei der Markierungswert als 0 ermittelt wird, wenn ein jeweiliges Bit des in der aktuellen Iteration zu decodierenden Codeworts mit dem entsprechenden Bit des ursprünglichen, in einer ersten Iteration zu decodierenden Codewort übereinstimmt, und der Markierungswert als 1 ermittelt wird, wenn ein jeweiliges Bit des zu decodierenden Codeworts sich von dem Bit im ursprünglichen, zu decodierenden Codewort unterscheidet; Bestimmen eines Umschalt-Schwellenwerts in der aktuellen Iteration, wobei der Umschalt-Schwellenwert so bestimmt wird, dass er zwischen einer Obergrenze und einer Untergrenze liegt; und der Umschalt-Schwellenwert in der aktuellen Iteration so bestimmt wird, dass er der Untergrenze des Umschalt-Schwellenwert entspricht, basierend darauf, dass die Prüfgleichungsgewichtung in der aktuellen Iteration und in mindestens zwei vorherigen Iterationen sequenziell abnimmt und die maximale Energie des in der vorherigen Iteration zu decodierenden Codeworts kleiner ist als die Summe aus dem Umschalt-Schwellenwert der vorherigen Iteration und einer Schrittweite, und die Differenz zwischen dem Umschalt-Schwellenwert der vorherigen Iteration und der Schrittweite kleiner ist als die Untergrenze des Umschalt-Schwellenwerts, wobei die maximale Energie des Codeworts der Energie des Bits mit der größten Energie unter der Mehrzahl von Bits des zu decodierenden Codeworts entspricht;
Vergleichen der Energie jedes Bits im zu decodierenden Codewort in der aktuellen Iteration mit dem Umschalt-Schwellenwert der aktuellen Iteration; Umschalten des Bits, wenn die Energie des Bits größer als der Umschalt-Schwellenwert in der aktuellen Iteration ist, oder Beibehalten des Bits in unveränderter Form, wenn die Energie des Bits kleiner oder gleich dem Umschalt-Schwellenwert in der aktuellen Iteration ist, um ein decodiertes Codewort in der aktuellen Iteration zu erhalten; und
Ausgeben des decodierten Codeworts in der aktuellen Iteration als ein Codewort, das in einer nächsten Iteration decodiert werden soll.

## Revendications

1. Décodeur (1046) pour un code de correction d'erreurs, comprenant : un premier circuit de traitement (501) configuré pour : obtenir une expression de contrôle et un poids d'expression de contrôle sur la base d'un mot de code à décoder dans une itération actuelle et d'une matrice de contrôle du code de correction d'erreurs, dans lequel l'expression de contrôle est obtenue en multipliant la matrice de contrôle et le mot de code à décoder dans l'itération actuelle, chaque bit dans l'expression de contrôle représentant un résultat d'une équation de contrôle, le résultat de l'équation de contrôle comprenant soit une validation, soit une erreur de contrôle ;
un deuxième circuit de traitement (502) configuré pour : obtenir une énergie du mot de code à décoder dans l'itération actuelle, l'énergie de chaque bit dans le mot de code étant obtenue en ajoutant un nombre d'erreurs de contrôle correspondant à chaque bit dans le mot de code à décoder à une valeur de marque du bit correspondant, la valeur de marque étant égale à 0 si un bit respectif du mot de code à décoder dans l'itération actuelle est identique au bit correspondant dans le mot de code d'origine à décoder dans une première itération, et la valeur de marque étant égale à 1 si un bit respectif du mot de code à décoder est différent du bit dans le mot de code d'origine à décoder ;
un processeur (503) configuré pour : déterminer un seuil de basculement dans l'itération actuelle,
dans lequel le seuil de basculement est déterminé de telle sorte que le seuil de basculement est à l'intérieur d'une limite supérieure et d'une limite inférieure ; et
le seuil de basculement dans l'itération actuelle est déterminé comme étant égal à la limite inférieure du seuil de basculement, sur la base du fait que le poids de l'expression de contrôle diminue de manière séquentielle dans l'itération actuelle et au moins deux itérations précédentes, et que l'énergie maximum du mot de code à décoder dans l'itération précédente est inférieure à la somme du seuil de basculement de l'itération précédente et d'une taille de pas, et la différence entre le seuil de basculement dans l'itération précédente et la taille de pas étant inférieure à la limite inférieure du seuil de basculement, l'énergie maximum du mot de code correspondant à l'énergie du bit présentant la plus grande énergie parmi la pluralité de bits du mot de code à décoder ; et
un circuit de basculement de bits (504) configuré pour :
comparer une énergie de chaque bit du mot de code à décoder dans l'itération actuelle au seuil de basculement dans l'itération actuelle ;
faire basculer le bit si l'énergie du bit est supérieure au seuil de basculement dans l'itération actuelle, ou laisser le bit inchangé si l'énergie du bit est inférieure ou égale au seuil de basculement dans l'itération actuelle, afin d'obtenir un mot de code décodé dans l'itération actuelle ; et
sortir le mot de code décodé dans l'itération actuelle comme étant un mot de code à décoder dans une itération suivante.

2. Décodeur (1046) selon la revendication 1, dans lequel le processeur (503) est en outre configuré pour :
déterminer que le seuil de basculement dans l'itération actuelle est inférieur au seuil de basculement dans une itération précédente, sur la base de la diminution séquentielle du poids de l'expression de contrôle dans l'itération actuelle et desdites au moins deux itérations précédentes ; ou
déterminer que le seuil de basculement dans l'itération actuelle est supérieur au seuil de basculement dans l'itération précédente, sur la base du fait que le poids de l'expression de contrôle augmente de manière séquentielle dans l'itération actuelle et au moins deux itérations précédentes ; ou
déterminer que le seuil de basculement dans l'itération actuelle est égal au seuil de basculement dans l'itération précédente, sur la base du fait que le poids de l'expression de contrôle reste inchangé ou alterne entre une diminution et une augmentation dans l'itération actuelle et lesdites au moins deux itérations précédentes.

3. Décodeur (1046) selon la revendication 1, dans lequel le processeur (503) est en outre configuré pour :
déterminer que le seuil de basculement dans l'itération actuelle est inférieur au seuil de basculement dans l'itération précédente, sur la base du fait que le poids de l'expression de contrôle diminue de manière séquentielle dans l'itération actuelle et lesdites au moins deux itérations précédentes, et que l'énergie maximum du mot de code à décoder dans l'itération précédente est inférieure à la somme du seuil de basculement de l'itération précédente et de la taille de pas ; ou
déterminer que le seuil de basculement dans l'itération actuelle est supérieur au seuil de basculement dans l'itération précédente, sur la base du fait que le poids de l'expression de contrôle augmente de manière séquentielle dans l'itération actuelle et lesdites au moins deux itérations précédentes, ou que l'énergie maximum du mot de code à décoder dans l'itération précédente est supérieure ou égale à la somme du seuil de basculement de l'itération précédente et de la taille de pas ; ou
déterminer que le seuil de basculement dans l'itération actuelle est égal au seuil de basculement dans l'itération précédente, sur la base du fait que le poids de l'expression de contrôle reste inchangé ou alterne entre une diminution et une augmentation dans l'itération actuelle et lesdites au moins deux itérations précédentes.

4. Décodeur (1046) selon la revendication 1, dans lequel le processeur (503) est en outre configuré pour :
déterminer que le seuil de basculement dans l'itération actuelle est inférieur au seuil de basculement dans l'itération précédente, sur la base du fait que le poids de l'expression de contrôle diminue de manière séquentielle dans l'itération actuelle et lesdites au moins deux itérations précédentes, et que l'une au moins des deux conditions suivantes est remplie : l'énergie maximum du mot de code à décoder dans l'itération précédente est inférieure à la somme du seuil de basculement de l'itération précédente et de la taille de pas, et une différence entre le seuil de basculement dans l'itération précédente et la taille de pas est supérieure à la limite inférieure du seuil de basculement ; ou
déterminer que le seuil de basculement dans l'itération actuelle est supérieur au seuil de basculement dans l'itération précédente, sur la base du fait que le poids de l'expression de contrôle augmente de manière séquentielle dans l'itération actuelle et lesdites au moins deux itérations précédentes, ou sur la base du fait que l'énergie maximum du mot de code à décoder dans l'itération précédente est supérieure ou égale à la somme du seuil de basculement de l'itération précédente et de la taille de pas, et que le seuil de basculement dans l'itération précédente est la limite inférieure du seuil de basculement ; ou
déterminer que le seuil de basculement dans l'itération actuelle est égal au seuil de basculement dans l'itération précédente, sur la base du fait que le poids de l'expression de contrôle reste inchangé ou alterne entre une diminution et une augmentation dans l'itération actuelle et lesdites au moins deux itérations précédentes.

5. Décodeur (1046) selon la revendication 1, dans lequel le processeur (503) est en outre configuré pour :
déterminer que le seuil de basculement dans l'itération actuelle est égal à une limite supérieure du seuil de basculement, sur la base du fait que le poids de l'expression de contrôle augmente de manière séquentielle dans l'itération actuelle et lesdites au moins deux itérations précédentes, et que la somme du seuil de basculement de l'itération précédente et de la taille de pas est supérieure à la limite supérieure du seuil de basculement.

6. Décodeur (1046) selon la revendication 1, dans lequel le processeur (503) est en outre configuré pour :
déterminer le seuil de basculement dans l'itération actuelle, sur la base d'un nombre de bits basculés dans une itération précédente, dans lequel
le seuil de basculement dans l'itération actuelle est déterminé comme étant inférieur au seuil de basculement dans l'itération précédente, sur la base du fait que le nombre de bits basculés dans l'itération précédente est égal à 0 ; et
déterminer un seuil de basculement dans la première itération, sur la base d'un résultat de comparaison entre le poids de l'expression de contrôle du mot de code à décoder dans la première itération et d'un seuil initial de poids de l'expression de contrôle ; et/ou
déterminer que le seuil de basculement dans la première itération est un premier seuil de basculement, sur la base du fait que le poids de l'expression de contrôle du mot de code à décoder dans la première itération est supérieur ou égal au seuil initial de poids de l'expression de contrôle ; ou
déterminer que le seuil de basculement dans la première itération est un deuxième seuil de basculement, sur la base du fait que le poids de l'expression de contrôle du mot de code à décoder dans la première itération est inférieur au seuil initial de poids de l'expression de contrôle, le premier seuil de basculement étant supérieur au deuxième seuil de basculement.

7. Décodeur (1046) selon la revendication 6, dans lequel le processeur (503) est configuré pour :
déterminer le premier seuil de basculement comme étant une limite supérieure du seuil de basculement, sur la base du fait que le poids de l'expression de contrôle du mot de code à décoder dans la première itération est supérieur ou égal au seuil initial du poids de l'expression de contrôle ; ou
déterminer le deuxième seuil de basculement comme étant une différence entre la limite supérieure du seuil de basculement et la taille de pas, sur la base du fait que le poids de l'expression de contrôle du mot de code à décoder dans la première itération est inférieur au seuil initial de poids de l'expression de contrôle, et mettre à jour la limite supérieure du seuil de basculement pour qu'elle corresponde au deuxième seuil de basculement.

8. Décodeur (1046) selon la revendication 1, dans lequel le premier circuit de traitement (501) est configuré pour :
calculer un nombre de bits de valeur 1 dans l'expression de contrôle, afin d'obtenir le poids de l'expression de contrôle.

9. Décodeur (1046) selon la revendication 1, dans lequel le décodeur (1046) inclut en outre :
un circuit de sortie, configuré pour : sortir le mot de code à décoder dans l'itération actuelle comme étant un mot de code décodé final, en fonction du fait que chaque bit de l'expression de contrôle de l'itération actuelle est égal à 0.

10. Système de mémoire (102), comprenant :
une mémoire, configurée pour : sortir des données lues ; et
un décodeur (1046) selon l'une quelconque des revendications précédentes.

11. Système de mémoire (102) selon la revendication 10, incluant en outre :
un codeur pour un code de correction d'erreurs, configuré pour :
recevoir des données d'écriture et coder les données d'écriture,
dans lequel la mémoire est en outre configurée pour : recevoir les données d'écriture codées.

12. Système de mémoire (102) selon la revendication 11, dans lequel le système de mémoire (102) inclut un contrôleur couplé à la mémoire, le contrôleur incluant le décodeur (1046) et le codeur.

13. Procédé de fonctionnement pour un système de mémoire (102), le procédé de fonctionnement incluant les étapes consistant à :
lire des données à l'aide d'une mémoire ; et
décoder un mot de code à décoder dans les données lues à l'aide d'un procédé de décodage pour un code de correction d'erreurs, le procédé de décodage comprenant les étapes consistant à :
obtenir une expression de contrôle et un poids d'expression de contrôle sur la base d'un mot de code à décoder dans une itération actuelle et d'une matrice de contrôle du code de correction d'erreurs, l'expression de contrôle étant obtenue en multipliant la matrice de contrôle et le mot de code à décoder dans l'itération actuelle, chaque bit de l'expression de contrôle représentant le résultat d'une équation de contrôle, le résultat de l'équation de contrôle comprenant soit une validation, soit une erreur de contrôle ;
obtenir une énergie du mot de code à décoder dans l'itération actuelle, l'énergie de chaque bit dans le mot de code étant obtenue en ajoutant un nombre d'équations de contrôle en erreur correspondant à chaque bit dans le mot de code à décoder à une valeur de marque du bit correspondant, la valeur de marque étant égale à 0 si un bit respectif dans le mot de code à décoder dans l'itération actuelle est identique au bit correspondant dans le mot de code d'origine à décoder dans une première itération, et la valeur de marque étant égale à 1 si un bit respectif du mot de code à décoder est différent du bit dans le mot de code d'origine à décoder ;
déterminer un seuil de basculement dans l'itération actuelle, le seuil de basculement étant déterminé de telle sorte que le seuil de basculement est à l'intérieur d'une limite supérieure et d'une limite inférieure ; et le seuil de basculement dans l'itération actuelle est déterminé comme étant égal à la limite inférieure du seuil de basculement, sur la base du fait que le poids de l'expression de contrôle diminue de manière séquentielle dans l'itération actuelle et au moins deux itérations précédentes, et que l'énergie maximum du mot de code à décoder dans l'itération précédente est inférieure à la somme du seuil de basculement de l'itération précédente et d'une taille de pas, et la différence entre le seuil de basculement dans l'itération précédente et la taille de pas étant inférieure à la limite inférieure du seuil de basculement, l'énergie maximum du mot de code correspondant à l'énergie du bit présentant la plus grande énergie parmi la pluralité de bits du mot de code à décoder ;
comparer une énergie de chaque bit dans le mot de code à décoder dans l'itération actuelle au seuil de basculement dans l'itération actuelle ;
faire basculer le bit si l'énergie du bit est supérieure au seuil de basculement dans l'itération actuelle, ou laisser le bit inchangé si l'énergie du bit est inférieure ou égale au seuil de basculement dans l'itération actuelle, afin d'obtenir un mot de code décodé dans l'itération actuelle ; et
sortir le mot de code décodé dans l'itération actuelle comme étant un mot de code à décoder dans une itération suivante.
